(19) Europäisches Patentamt
European Patent Office
Office européen des brevets

(11) Veröffentlichungsnummer: **0 003 552**
**B1**

(12) **EUROPÄISCHE PATENTSCHRIFT**

(45) Veröffentlichungstag der Patentschrift: **26.05.82**

(21) Anmeldenummer: **79100274.4**

(22) Anmeldetag: **31.01.79**

(51) Int. Cl.³: **C 08 F 8/30**, C 08 G 85/00, C 08 B 37/00, G 03 F 7/10, G 03 C 1/68

(54) **Unter der Einwirkung von Licht vernetzbare Polymere mit seitenständigen tricyclischen Imidylgruppen, ihre Herstellung und ihre Verwendung.**

(30) Priorität: **08.02.78 CH 1401/78**

(43) Veröffentlichungstag der Anmeldung:
**22.08.79 Patentblatt 79/17**

(45) Bekanntmachung des Hinweises auf die Patenterteilung:
**26.05.82 Patentblatt 82/21**

(84) Benannte Vertragsstaaten:
**CH DE FR GB IT NL SE**

(56) Entgegenhaltungen:
**CHEMICAL ABSTRACTS, Vol. 65, 1966, Zusammenfassung Nr. 12148h, Columbus, Ohio, USA**
**TAKEAKI KATO et al: "N-(Hydroxymethyl)-3,4-dihydronaphthalene-1,2-dicarboximides"**

Die Akte enthält technische Angaben die nach dem Eingang der Anmeldung eingereicht wurden und die nicht in dieser Patentschrift enthalten sind.

(73) Patentinhaber: **CIBA-GEIGY AG**
**Patentabteilung Postfach**
**CH-4002 Basel (CH)**

(72) Erfinder: **Zweifel, Hans, Dr.**
**Lothringerstrasse 93**
**CH-4056 Basel (CH)**
Erfinder: **Bellus, Daniel, Dr.**
**Unterm Schellenberg 81**
**CH-4125 Riehen (CH)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 003 552 B1

Unter der Einwirkung von Licht vernetzbare Polymere mit seitenständigen tricyclischen Imidylgruppen, ihre Herstellung und ihre Verwendung

Die vorliegende Erfindung betrifft neue unter der Einwirkung von Licht vernetzbare Polymere mit seitenständigen tricyclischen Imidylgruppen, Verfahren zu deren Herstellung und deren Verwendung zur Vernetzung unter der Einwirkung von Licht, besonders zum Erzeugen von Abbildungen.

Aus der Literatur ist bekannt, dass sich verschiedenartig substituierte Imide, vor allem Maleinimide, zur Herstellung von vernetzbaren (härtbaren) Polymeren eignen. Die japanischen Offenlegungsschriften 50—5376, 50—5377, 50—5378, 50—5379 und 50—5380 beschreiben generisch verschiedene zur Herstellung von lichtvernetzbaren Polymeren geeignete $\alpha$-Arylmaleinimide und N-substituierte Derivate davon, die in $\beta$-Stellung noch durch eine Halogenatom, eine Cyanogruppe oder eine niedere Alkylgruppe substituiert sein können, wobei die genannte Alkylgruppe zusammen mit dem ortho-ständigen C-Atom der $\alpha$-Arylgruppe auch einen Ring bilden kann. Die konkrete Offenbarung beschränkt sich jedoch auf $\alpha$-Phenyl- und $\alpha$-Phenyl-$\beta$-cyanomaleinimide und N-substituierte Derivate davon. In den japanischen Offenlegungsschriften 49—128991, 49—128992, 49—128993, 50—9682, 50—10884 und 50—77363 wird die Herstellung von lichtvernetzbaren Polymeren beschrieben, z.B. durch Umsetzung von N-substituierten $\alpha$-Arylmaleinimiden der vorerwähnten Art, die am N-Substituenten Hydroxyl-, Amino-, Carbonsäure- oder Carbonsäurechloridgruppen aufweisen, mit Polymeren mit entsprechenden funktionellen Gruppen. Aus den deutschen Offenlegungsschriften 2.031.573, 2.032.037 und 2.626.795 sind weitere Imidylderivate bzw. lichtvernetzbare Polymere mit end- oder seitenständigen Imidylgruppen, besonders Maleinimid-, Dimethylmaleinimid-, Nadicimid- und Tetrahydrophthalimidgruppen, bekannt.

Diese vorbekannten Imide bzw. die daraus herstellbaren vernetzbaren Polymeren haben den Nachteil einer relativ geringen photochemischen Empfindlichkeit, weshalb sie sich nicht oder nur schlecht für zahlreiche Anwendungen eignen, für die hochlichtempfindliche Substanzen benötigt werden, oder aber sie erfordern die Mitverwendung von bekannten Photosensibilisatoren, wie Benzophenon, Thioxanthon und dergleichen.

Aufgabe der Erfindung war daher die Bereitstellung von neuen unter der Einwirkung von Licht vernetzbaren Polymeren, die eine hohe UV-Absorption aufweisen und deswegen auch ohne Zusatz von Photosensibilisatoren eine hohe Vernetzungsgeschwindigkeit gewährleisten.

Gegenstand der Erfindung sind neue unter der Einwirkung von Licht vernetzbare Polymere, deren Durchschnittsmolekulargewicht mindestens 1000 beträgt und die seitenständige Imidylgruppen der Formel I

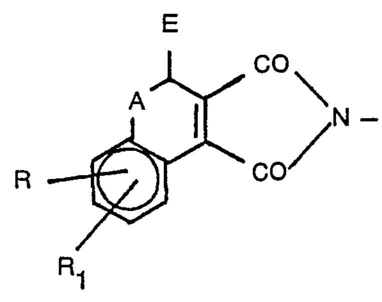

(I)

aufweisen, worin

A — $-CH_2-$, $-CH_2CH_2-$ oder $-OCH_2-$ mit an den aromatischen Ring gebundenem Sauerstoffatom und

E — Wasserstoff

oder

A — $-O-$ und

E — $-CH_3$ und

R und $R_1$ — unabhängig voneinander Wasserstoff, Halogen, Alkyl mit 1—4 C—Atomen oder Methoxy bedeuten, wobei der Anteil an Imidylgruppen der Formel I mindestens 5 Prozent, bevorzugt 5—100 und insbesondere 20—100 Prozent, bezogen auf die Anzahl der wiederkehrenden Strukturelemente des Polymeren, beträgt.

Die erfindungsgemässen Polymeren weisen zweckmässig ein Durchschnittsmolekulargewicht von mindestens 1000 bis 1 000 000 und insbesondere ein Durchschnittsmolekulargewicht von etwa 1000 bis 200 000 auf.

Bei den erfindungsgemässen Polymeren handelt es sich z.B. um Polyester, Polyesteramide, Polyamide, Polyimide, Polyamid-imide, Polyester-amid-imide, Polyäther, Polyamine, Polyimine, Polyurethane, Polykondensate auf der Basis von Phenol-Formaldehyd, Polysaccharide, Gelatine, Organopolysiloxane und um Polymere, welche durch Homo- oder Copolymerisation von C=C-Doppelbindungen enthaltenden Monomeren erhalten werden.

Die erfindungsgemässen Polymere lassen sich nach an sich bekannten Synthesemethoden zur Herstellung von Makromolekülen mit photoaktiven seitenständigen Gruppen herstellen. Grundsätzlich kommen folgende Wege in Betracht:

1. Einbau der tricyclischen Imidylgruppen der Formel I in eine bestehende Polymerkette;

2. Aufbau der Polymerkette aus Monomeren, welche die lichtempfindliche tricyclische Imidylgruppe bereits enthalten, wobei die Polymerkette durch Polymerisation, Polyaddition oder Polykondensation aufgebaut werden kann.

Teilweise können mit den Methoden 1 und 2 gleiche Produkte erhalten werden, so dass sich wahlweise die Methode 1 oder 2 anwenden lässt. Werden die tricyclischen Imidylgruppen in eine bereits vorhandene Polymerkette eingebaut, so erfolgt dieser Einbau entweder durch eine Kondensationsreaktion oder durch eine Additionsreaktion unter gleichzeitiger Oeffnung eines Ringsystems, z.B. einer Dicarbonsäureanhydridgruppe oder einer Epoxidgruppe.

Nach der vorerwähnten Aufbau-Methode können erfindungsgemässe Polymere dadurch hergestellt werden, dass man eine Verbindung der Formel II

$$\text{Imidyl}\!-\!\!(Y)_{n-1}\!\!-\!X \qquad \text{(II)}$$

worin
"imidyl" einen Rest der Formel I darstellt,
n die Zahl 1 oder 2 und
Y gegebenenfalls durch Heteroatome unterbrochenes Alkylen mit 1—30 C—Atomen, Cycloalkylen mit 5 oder 6 C—Atomen, einen Dicyclohexylmethanrest, Arylen mit 6—10 C—Atomen, Aralkylen oder Alkylarylen mit 7 oder 8 C—Atomen bedeuten, wobei die genannten Reste Y auch substituiert sein können,
X, bei n = 1, eine Gruppe de Formeln

—NH—CO—Alkenyl oder 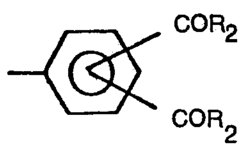

und, bei n = 2, —CO—O—Alkenyl, —O—Alkenyl, —O—CO—Alkenyl, —NH—CO—Alkenyl oder —S—CO—Alkenyl bedeutet, die $—COR_2$ in meta- oder para-Stellung zueinander an den Benzolring gebunden sind und die $R_2$ je —OH, —Cl, Alkoxy mit 1—4 C—Atomen oder Phenoxy bedeuten oder die $—COR_2$ in ortho-Stellung zueinander an den Benzolring gebunden sind und eines von $R_2$ —OH oder $—O^-M^+$ und das andere

$$—O(CH_2)_qOCO—\overset{\displaystyle Q_1}{\overset{|}{C}}{=}CH_2$$

bedeutet oder beide $R_2$ zusammen —O— bilden,
$M^+$ ein Alkalimetall-, das Pyridinium- oder ein Trialkylammonium kation mit 3—24 und insbesondere 3—12 C—Atomen,
$Q_1$ Wasserstoff oder Methyl und
q eine ganze Zahl von 2—4 bedeuten,
wobei in den obigen Gruppen Alkenylteile 2—4 C—Atome aufweisen, gegebenenfalls in Gegenwart von Comonomeren zur Reaktion bringt, wobei das Mol-Verhältnis von Verbindungen der Formel II zu Comonomerem 1:20 bis 1:0 und bevorzugt 1:4 bis 1:0 beträgt.

Nach der vorerwähnten Einbau-Methode lassen sich erfindungsgemässe Polymere zum Beispiel dadurch herstellen, dass man eine Verbindung der Formel III

$$\text{Imidyl}\!-\!\!(Y)_{n-1}\!\!-\!X' \qquad \text{(III)}$$

worin
"Imidiyl" einen Rest der Formel I darstellt,
n und Y die unter Formel II angegebene Bedeutung haben und X', bei n = 1, eine Gruppe der Formel

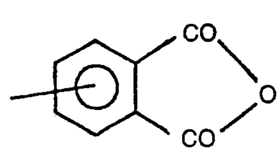

und, bei n = 2, —OH, —$NH_2$, —NH—Alkyl mit 1—4 C—Atomen, —SH, —COOH oder —COCl bedeutet,
mit einem Polymeren mit entsprechenden funktionellen Gruppen in einem Verhältnis von 1:20 bis 1:1, bevorzugt 1:5 bis 1:1, bezogen auf die Anzahl der wiederkehrenden Strukturelemente des Polymeren, zur Reaktion bringt.

Verbindungen der Formel III, worin X' —COOH, —COCl oder eine Phthalsäureanhydridgruppe bedeutet, lassen sich beispielsweise mit Polymeren umsetzen, die freie —OH—, —$NH_2$—, —NH—Alkyl- oder —SH—Gruppen aufweisen. Verbindungen der Formel III, worin n die Zahl 2 und X' —OH, —$NH_2$, —NH—Alkyl mit 1—4 C—Atomen der —SH bedeuten, eignen sich z.B. zur Umsetzung mit Polymeren, die —COOH— oder Anhydridgruppen aufweisen. Schliesslich können Verbindungen der Formel III, worin n die Zahl 2 und X' —OH, —$NH_2$, —NH—Alkyl mit 1—4 C-Atomen, —SH oder —COOH bedeuten, auch mit Polymeren umgesetzt werden die,

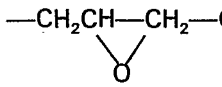 Gruppen aufweisen.

Durch Y dargestellte definitionsgemässe Alkylen-, Cycloalkylen-, Dicyclohexylmethan-, Arylen-, Aralkylen- oder Alkylarylengruppen können unsubstituiert oder substituiert sein, z.B. durch Alkyl- oder Alkoxygruppen mit je 1—4 C-Atomen und insbesondere je 1 oder 2 C-Atomen, Nitrogruppen oder Halogenatome, wie Chlor, Brom oder Fluor.

Alkylengruppen Y können geradkettig oder verzweigt sein und ein oder mehrere Heteroatome enthalten, besonders S- oder O-Atome. Bevorzugt sind unsubstituierte geradkettige oder verzweigte Alkylengruppen Y, besonders solche mit 2—10 C-Atomen. Beispiele von geeigneten Alkylengruppen Y sind die Aethylengruppe, die 1,3- oder Isopropylengruppe, die 2,2-Dimethylpropylengruppe, die Tetramethylen-, Hexamethylen-, Octamethylen- und Decamethylengruppe.

Stellt Y eine Cycloalkylgruppe dar, so ist diese bevorzugt unsubstituiert. Insbesondere handelt es sich um die 1,3- und vor allem die 1,4-Cyclohexylengruppe.

Sind Arylengruppen Y substituiert, so weisen diese Gruppen pro Ring bevorzugt nur einen Substituenten auf, insbesondere eine Alkyl- oder Alkoxygruppe mit je 1—4 und vor allem 1 oder 2 C-Atomen oder eine Nitrogruppe. Beispiele geeigneter Arylengruppen Y sind die 1,2-, 1,3- und 1,4-Phenylengruppe, die 1,3-Tolylengruppe, die 5-Methoxy-1,3-phenylengruppe, die 3-Nitro-1,4-phenylengruppe, die 1,7- und 2,7-Naphthylengruppe. Bevorzugt sind unsubstituierte Arylengruppen, besonders die 1,4- und die 1,3-Phenylengruppe.

Als Aralkylengruppen Y kommen vor allem die Gruppen

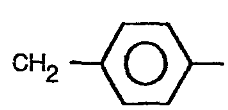 und 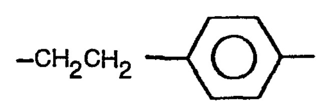

und als Alkylarylengruppen Y vor allem die Gruppen

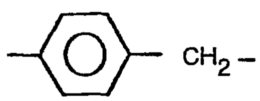 und 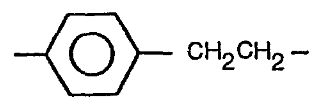

in Betracht.

Definitionsgemässe Alkyl- und Alkoxygruppen R, $R_1$, $R_2$ und $R_2'$ sowie Alkyl- oder Alkenylteile von definitionsgemässen Substituenten X oder X' können ebenfalls geradkettig oder verzweigt sein.

Als Beispiele definitionsgemässer Alkyl-, Alkoxy- und Alkenylgruppen seien genannt: die Methyl-Aethyl-, Propyl-, Isopropyl-, n-Butyl-, tert-Butyl-, Methoxy-, Aethoxy-, n-Propoxy-, Isopropoxy-, n-Butoxy-, tert-Butoxy-, Vinyl-, Allyl- oder Isopropenylgruppe.

Weist der Substituent X eine Alkenylgruppe auf, so handelt es sich insbesondere um Gruppen

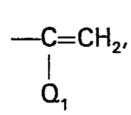

worin $Q_1$ Wasserstoff oder Methyl bedeutet.

Stellt R oder $R_1$ ein Halogenatom dar, so handelt es sich vor allem um Chlor-, Brom- oder Fluoratome. Alkylgruppen R und $R_1$ sind mit Vorteil geradkettig und weisen je 1 oder 2 C-Atome auf. Bevorzugt stellen R und $R_1$ jedoch Wasserstoff dar.

Alkoxygruppen $R_2$ bzw. $R_2'$ sind ebenfalls bevorzugt geradkettig und weisen 1 oder 2 C-Atome auf.

$M^+$ stellt beispielsweise das Lithium-, Natrium-, Kalium, Trimethylammonium-,

Triäthylammonium-, Methyldiäthylammoniumkation oder das Tri-n-octylammoniumkation dar. Bevorzugt bedeutet $M^+$ ein Alkalimetallkation, besonders das Natriumkation.

Unter den Gruppen

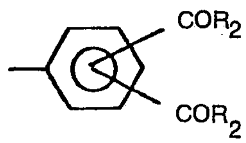 bzw. 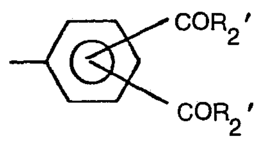

sind solche bevorzugt, worin die Gruppen $—COR_2$ und $—COR_2'$ in 3,5-Stellung an den Benzolring gebunden sind und die $R_2$ bzw. $R_2'$ je —OH, Methoxy, Aethoxy, Phenoxy oder Chlor darstellen, oder solche, worin die $—COR_2—$ bzw. $—COR_2'—$ Gruppen in ortho-Stellung zueinander an den Benzolring gebunden sind und $R_2$ und $R_2'$ zusammen —O— bedeuten.

Bevorzugt sind tricyclische Imidylgruppen der Formel I bzw. Verbindungen der Formel II oder III, worin R und $R_1$ je Wasserstoff, A $—CH_2—$, $—CH_2CH_2—$ oder $—OCH_2—$ mit an den aromatischen Ring gebundenem Sauerstoffatom und E Wasserstoff bedeuten.

Verbindungen der Formel II, worin X eine polymerisierbare Gruppe darstellt oder eine polymerisierbare Gruppierung enthält, eignen sich zur Homopolymerisation oder zur Copolymerisation mit anderen äthylenisch ungesättigten Comonomeren, insbesondere solchen der weiter unten angegebenen Art. Verbindungen der Formel II, worin X eine Gruppe

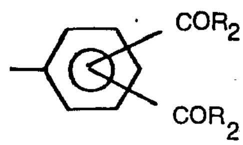

darstellt, worin die $—COR_2$ in meta- oder para-Stellung zueinander an den Benzolring gebunden sind und die $R_2$ je —OH, —Cl, Alkoxy mit 1—4 C-Atomen oder Phenoxy bedeuten, oder worin die $—COR_2$ in o-Stellung zueinander an den Benzolring gebunden sind und die $R_2$ zusammen —O— bilden, können mit geeigneten Diaminen, Diolen, Aminoalkoholen und gegebenenfalls weiteren Di-, Tri- oder Tetracarbonsäurederivaten polykondensiert werden. Als Co-Kondensationskomponenten können an sich beliebige aliphatische, cycloaliphatische, araliphatische, carbocyclisch-aromatische oder heterocyclische Verbindungen eingesetzt werden. Als Beispiele von Ausgangspolymeren, die sich mit Verbindungen der Formel III umsetzen lassen, seien erwähnt: Polyacrylsäure, Polymethacrylsäure, Copolymere aus diesen Säuren und anderen äthylenisch ungesättigten Monomeren, Copolymere, aufgebaut aus Maleinsäureanhydrid und äthylenisch ungesättigten Monomeren, wie Methylvinyläther, Aethylen, Styrol, Hexen-1, Decen-1, Tetradecen-1 und Octadecen-1, Polymere mit freien Hydroxylgruppen, wie Homo- und Copolymere von Acrylsäure- und Methacrylsäurehydroxy- alkylestern, Polyvinylalkohole, native oder regenerierte Cellulose, Cellulosederivate, Hydroxyalkylcellulose, Polyäther mit freien OH-Gruppen, Phenol-Formaldehyd-Polykondensate, Polymere mit freien Glycidylgruppen, wie Copolymere auf der Basis von Acryl- und Methacrylsäureglycidylestern, Polyäthylenimine und Polymere mit freien seitenständigen Aminogruppen, z.B. Poly-p-aminostyrol.

Bevorzugt sind erfindungsgemässe Polymere, die wiederkehrende Strukturelemente der Formeln IV bis VII und X bis XIV aufweisen:

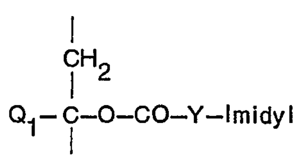 (IV),

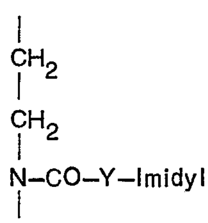 (V),

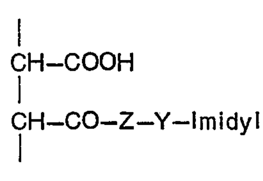 (VI),

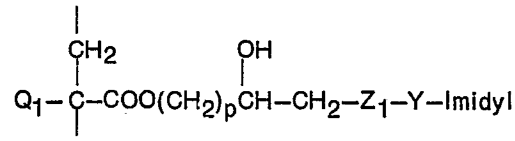

(VII),

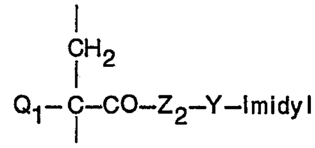

(X),

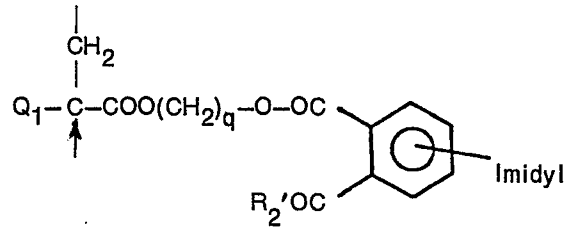

(XI),

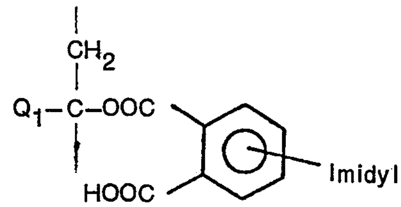

(XII),

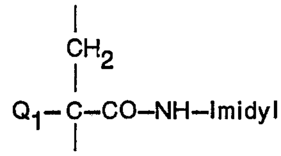

(XIII)

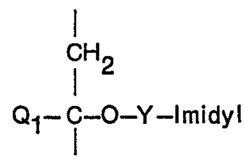

(XIV)

In den obigen Formeln bedeuten: "Imidyl" einen Rest der Formel I, $R_2'$ —OH oder —$O^-M^+$, $Q_1$ Wasserstoff oder Methyl q eine ganze Zahl von 2 bis 4, p die Zahl 1 oder 2, Z —O—, —NH—, —N—Alkyl mit 1—4 C—Atomen oder —S—, $Z_1$ —OCO—, —NH—, —N—Alkyl mit 1—4 C—Atomen, —O— oder —S—, und $Z_2$ —O—, —S— oder —NH— und Y die unter Formel II angegebene Bedeutung.

Bevorzugte Polymere gemäss der Erfindung sind auch solche, welche ausser einem oder mehreren der Strukturelemente der Formeln IV bis VII und X bis XIV gleichzeitig Strukturelemente der Formel XVI

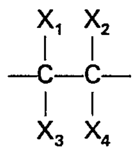

(XVI)

enthalten,
worin
$X_1$ und $X_3$ je Wasserstoff,
$X_2$ Wasserstoff, Chlor oder Methyl,
$X_4$ Wasserstoff, Methyl, Chlor, —CN, —COOH, —$CONH_2$, Phenyl, Methylphenyl, Methoxyphenyl, Cyclohexyl, Pyridyl, Imidazolyl, Pyrrolidyl, —COO-Alkyl mit 1—12 C-Atomen im Alkylteil, —COO-Phenyl,

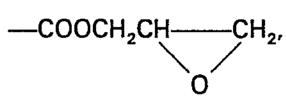

—COO-Alkyl—OH mit 1—3 C-Atomen im Alkylteil, —OCO-Alkyl mit 1—4 C-Atomen im Alkyl, —OCO-Phenyl, —CO-Alkyl mit 1—3 C-Atomen im Alkyl, Alkoxy mit 1—6 C-Atomen oder Phenoxy

oder $X_1$ und $X_2$ je Wasserstoff und $X_3$ und $X_4$ zusammen die Gruppierung

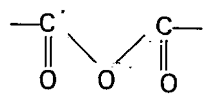

oder je —COOH oder —COOAlkyl mit 1—6 C-Atomen im Alkyl darstellen.

Von diesen zuletzt genannten Mischpolymeren sind besonders solche interessant, welche Strukturelement der Formel XVI enthalten, worin $X_1$ und $X_3$ je Wasserstoff, $X_2$ Wasserstoff oder Methyl und $X_4$ —OCOCH, —COOH oder —COOAlkyl mit 1—8 C-Atomen im Alkyl darstellen oder $X_1$, $X_2$ und $X_3$ je Wasserstoff bedeuten und $X_4$ —CN, Chlor oder Phenyl bedeutet.

Weitere bevorzugte Polymere gemäss der Erfindung sind Homo- oder Copolykondensate mit Durchschnittsmolekulargewichten zwischen 1000 und 50 000, welche die Maleinimidgruppen der Formel I in Molekülkettengliedern der Formel XV

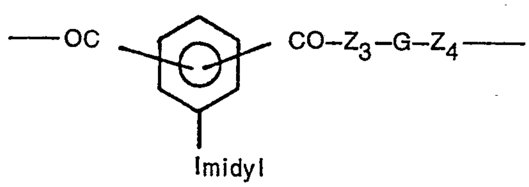

(XV)

enthalten, in der

$Z_3$ und $Z_4$ unabhängig voneinander —O—, —NH— oder —S— und

G einen aliphatischen Rest mit mindestens 2 C-Atomen, einen cycloaliphatischen, araliphatischen, carbocyclisch-aromatischen oder heterocyclisch-aromatischen Rest bedeuten

oder —$Z_3$—G—$Z_4$— eine Gruppierung der Formeln

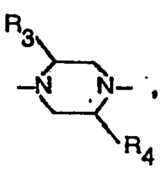,
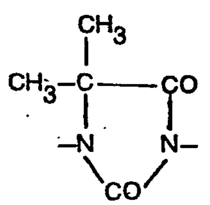,
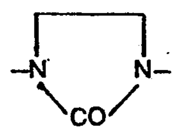
oder

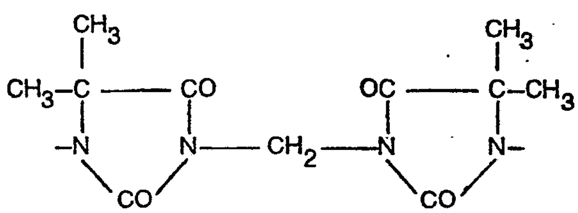
darstellt und

$R_3$ und $R_4$ unabhängig voneinander Wasserstoff, Methyl oder Phenyl bedeuten, wobei in Formel XV die beiden Carbonylgruppen in meta- oder para-Stellung zueinander an den Benzolring gebunden sind.

Weitere bevorzugte Polymere sind dadurch gekennzeichnet, dass sie ausser einem oder mehreren Strukturelementen der Formel XV gleichzeitig Strukturelementen der Formel XVII

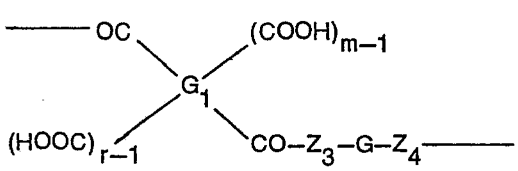

(XVII)

enthalten, worin für $Z_3$, $Z_4$ und G das unter Formel XV Angegebene gilt, m und r unabhängig voneinander die Zahl 1 oder 2, und $G_1$ einen aliphatischen Rest mit mindestens 2 C-Atomen, einen cycloaliphatischen, araliphatischen, carbocyclisch-aromatischen oder heterocyclisch-aromatischen Rest, in dem die Carbonyl- und Carboxylgruppen an verschiedene und bei cyclischen Resten $G_1$ paarweise an benachbarte C-Atome gebunden sind, bedeuten.

G in der Bedeutung eines aliphatischen Restes stellt insbesondere geradkettiges oder verzweigtes Alkylen mit 2—12 C-Atomen dar, wobei die Alkylenkette auch durch Heteroatome, wie O—, S— oder N-Atome, unterbrochen sein kann. Stellt G einen cycloaliphatischen Rest dar, so handelt es sich z.B. um die 1,3- oder 1,4-Cyclohexylen-, Dimethylen-1,4-cyclohexan- oder die Dicyclohexylmethangruppe. Als araliphatische Reste G kommen vor allem 1,3-, 1,4- oder 2,4-Bis-alkylenbenzol-, 4,4'-Bisalkylendiphenyl- und 4,4'-Bis-alkylendiphenyläthergruppen in Betracht, vor allem die 1,3- und 1,4-Xylylengruppe und die 1,3-Tolylengruppe. Carbocyclisch-aromatische Reste G können ein- oder mehrkernig, kondensiert oder nicht kondensiert sein, wobei im letzteren Falle die Aromatenkerne über ein Brückenglied miteinander verbunden sind. Insbesondere handelt es sich dabei um gegebenenfalls durch Alkyl- oder Alkoxygruppen mit je 1—4 C-Atomen oder durch Halogenatome, wie Chlor, Brom oder Fluor substituierte Phenylen- oder Naphthylengruppen oder um Gruppen der Formel

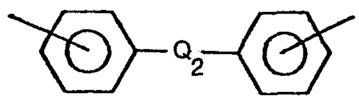

worin $Q_2$ —O—, —$CH_2$—, —S—, —$SO_2$— oder —$C(CH_3)_2$— bedeutet. Stellt Ge einen heterocyclisch-aromatischen Rest dar, so handelt es sich beispielsweise um N—, O— und/oder S-haltige fünf- oder sechsgliedrige Ringsysteme.

$G_1$ in der Bedeutung eines aliphatischen Restes ist z.B. geradkettiges oder verzweigtes Alkylen mit 2—12 C-Atomen, besonders geradkettiges Alkylen mit 2—10 C-Atomen. Als cycloaliphatische Rest $G_1$ kommen vor allem 5- oder 6-gliedrige Cycloalkylgruppen in Betracht. Bedeutet $G_1$ einen carbocyclisch-aromatischen Rest, so weist dieser bevorzugt mindestens einen 6-gliedrigen Ring auf; insbesondere handelt es sich dabei um monocyclische, um kondensierte bicyclische oder um nicht kondensierte bicyclische Reste, wobei die letzteren auch über ein Brückenglied, wie —CO— oder —$CH_2$—, miteinander verbunden sein können. Als heterocyclisch-aromatische Reste $G_1$ kommen besonder 5- oder 6-gliedrige heterocyclisch-aromatische, gegebenenfalls benzokondensierte, O—, N— und/oder S-haltige Ringsysteme in Betracht.

Bei m und $r = 1$ stellt $G_1$ bevorzugt geradkettiges Alkylen mit 2—10 C-Atomen, 1,3- oder 1,4-Phenylen dar. Bedeutet eines von m und r die Zahl 1 und das andere die Zahl 2, so stellt $G_1$ insbesondere eine Benzoltriylgruppe dar. Bei m und $r = 2$ bedeutet $G_1$ vor allem eine Benzoltetraylgruppe oder das Benzophenonringsystem.

Technisch besonders vorteilhafte Mischpolykondensate der zuletzt beschriebenen Art sind solche, die wiederkehrende Strukturelemente der Formel XVa

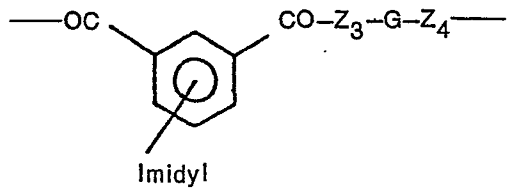

(XVa)

und gegebenenfalls wiederkehrende Strukturelemente der Formel XVIIa

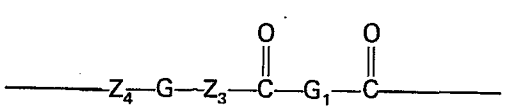

(XVIIa)

aufweisen, worin

"Imidyl" einen Rest der Formel I darstellt, in dem

R und $R_1$ je Wasserstoff,

A —$CH_2$—, —$CH_2CH_2$— oder —$OCH_2$— mit and den aromatischen Ring gebundenem Sauerstoffatom und

E Wasserstoff bedeuten.

$Z_3$ und $Z_4$ je —NH— oder —O—, G Alkylen mit 2—12 C-Atomen oder Arylen mit 6—10 C-Atomen, das durch Halogenatome oder Alkylgruppen mit 1—4 C-Atomen substituiert sein kann und $G_1$ Alkylen mit 2—10 C-Atomen, 1,3- oder 1,4-Phenylen bedeuten oder —$Z_4$—G—$Z_3$— die Gruppierung

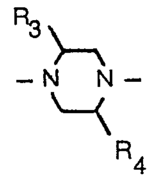

darstellt, worin $R_3$ und $R_4$ je Wasserstoff oder methyl bedeuten.

Polymere mit wiederkehrenden Strukturelementen der Formel XV können dadurch erhalten werden, dass man eine Verbindung der Formel II, worin n die Zahl 1 und X eine Gruppe der Formel

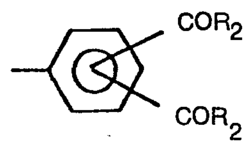

darstellt, worin die $—COR_2$ in meta- oder para-Stellung zueinander an den Benzolring gebunden sind und die $R_2$ je —OH, —Cl, Alkoxy mit 1—4 C-Atomen oder Phenoxy bedeuten, mit einer Verbindung der Formel XVIII

$$HZ_3—G—Z_4H \qquad (XVIII)$$

gegebenenfalls in Gegenwart eines Di, Tri- oder Tetracarbonsäurederivats, z.B. solchen der Formel XIX

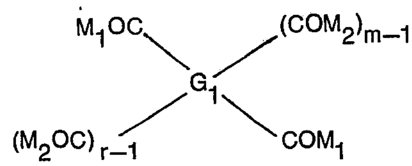

(XIX),

polykondensiert, wobei für $Z_3$, $Z_4$, G, $G_1$, m und r das oben Angegebene gilt und

$M_1$ bei m und r = 1, —OH, —Cl, Alkoxy mit 1—4 C-Atomen oder Phenoxy und bei m und/oder r = 2, zusammen mit $M_2$ —O— bedeutet.

Schliesslich können Polymere, die wiederkehrende Strukturelemente der Formeln IV bis VIII oder XII aufweisen, dadurch hergestellt werden, dass man

A) eine Verbindung der Formel III, worin Y die angegebene Bedeutung hat, n die Zahl 2 und X' —COCl oder —COOH bedeuten, mit einem Polymeren mit wiederkehrenden Strukturelementen der Formeln IVa oder Va

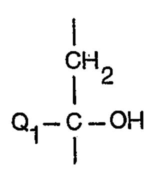

(IVa) oder

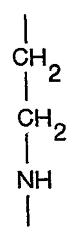

(Va),

B) eine Verbindung der Formel III, worin Y die angegebene Bedeutung hat, n die Zahl 2 und X' —OH, $—NH_2$, —NH-Alkyl mit 1—4 C-Atomen oder —SH darstellen, mit einem Polymeren mit wiederkehrenden Strukturelementen der Formel VIa

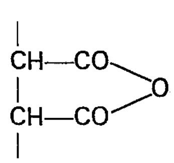

(VIa)

C) eine Verbindung der Formel III, worin Y die angegebene Bedeutung hat, n die Zahl 2 und X' —OH, $—NH_2$, —NH-Alkyl mit 1—4 C-Atomen, —SH oder —COOH bedeuten, mit einem Polymeren mit wiederkehrenden Strukturelementen der Formeln VIIa oder VIIIa

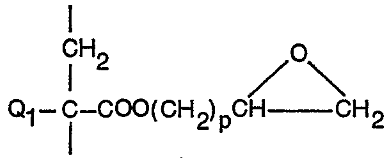

(VIIa) oder

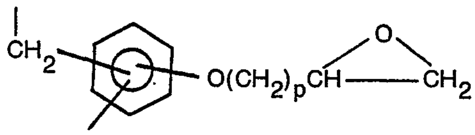

(VIIIa)

oder

D) eine Verbindung der Formel III, worin n die Zahl 1 und X′ eine Gruppe

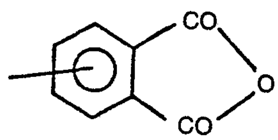

darstellt, mit einem Polymeren mit wiederkehrenden Strukturelementen der Formel IVa zur Reaktion bringt, wobei in den obigen Formeln $Q_1$ und p die früher angegebene Bedeutung haben.

Besonders bevorzugt sind Polymere, die wiederkehrende Strukturelemente der Formeln IV, V, VI, VII, VIII, X, XII oder XIV und gegebenenfalls wiederkehrende Strukturelemente der Formel XVI aufweisen, worin im Imidylrest der Formel I R und $R_1$ je Wasserstoff, A $-CH_2-$, $-CH_2CH_2-$ oder $-OCH_2-$ mit an den aromatischen Ring gebundenem Sauerstoffatom und E Wasserstoff bedeuten, Y geradkettiges oder verzweigtes Alkylen mit 2—11 C-Atomen 1,3- oder 1,4-Phenylen oder 1,4-Cyclohexylen, Z —O— oder —NH—, $Z_1$ —OCO— oder —NH—, p die Zahl 1 und $Q_1$ Methyl oder insbesondere Wasserstoff bedeuten und $X_1$, $X_2$, $X_3$ und $X_4$ die oben angegebene bevorzugte Bedeutung haben.

Eine besondere, bevorzugte Art von Polymeren gemäss der Erfindung stellen solche auf der Ausgangsbasis von Novolaken dar, welche wiederkehrende Strukturelemente der Formel VIII

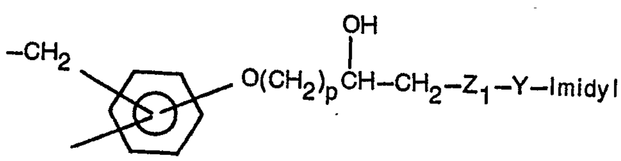

(VIII)

in der p, $Z_1$, Y und Imidyl die gleiche Definition wie in Formel VII haben, aufweisen.

Bevorzugt sind schliesslich auch Polymere, welche wiederkehrende Strukturelemente der Formeln IV, V, VI VII, VIII, X, XII oder XIV und gegebenenfalls wiederkehrende Strukturelemente der Formel XVI aufweisen, worin im Imidylrest der Formel I R und $R_1$ je Wasserstoff, A $-CH_2-$, $-CH_2CH_2-$ oder $-OCH_2-$ mit an den aromatischen Ring gebundenem Sauerstoffatom und E Wasserstoff bedeuten, Y geradkettiges oder verzweigtes Alkylen mit 2—11 C-Atomen, 1,3- oder 1,4-Phenylen oder 1,4-Cyclohexylen, Z —O— oder —NH—, $Z_1$ —OCO— oder —NH—, p die Zahl 1, $Q_1$ Methyl oder insbesondere Wasserstoff, $X_1$ und $X_3$ je Wasserstoff, $X_2$ Wasserstoff oder Methyl und $X_4$ $-OCOCH_3$, —COOH oder —COOAlkyl mit 1—8 C-Atomen im Alkyl oder $X_1$, $X_2$ und $X_3$ je Wasserstoff und $X_4$ —CN, Chlor oder Phenyl bedeuten.

Der Einbau erfindungsgemässer tricyclischer Imidylgruppen in bestehende Polymerketten mittels Kondensations- oder Additionsreaktion sowie der Aufbau von erfindungsgemässen Polymeren, z.B. solchen mit Strukturelementen der Formel XV, durch Polykondensation geeigneter Monomere können auf an sich bekannte Weise erfolgen, zweckmässig bei Temperaturen von etwa −50°C bis +150°C. Die Umsetzung wird vorzugsweise in einem inerten organischen Lösungsmittel oder einem Lösungsmittelgemisch durchgeführt, für Kondensationsreaktionen bevorzugt bei Temperaturen von etwa −20°C bis +100°C. Additionsreaktionen werden zweckmässig bei erhöhter temperatur, im allgemeinen bei Temperaturen zwischen etwa 80 und 120°C oder bei Rückflusstemperatur vorgenommen.

Geeignete Lösungsmittel zur Durchführung der Kondensations- oder Additionsreaktionen sind beispielsweise:

—aliphatische oder cyclische Ketone, wie Aceton, Methyläthylketon, Isopropylmethylketon, Cyclohexanon, Cyclopentanon und γ-Butyrolacton;

—cyclische Aether, wie Tetrahydrofuran, Tetrahydropyran und Dioxan;

—cyclische Amide, wie N-Methyl-2-pyrrolidon, N-Aethyl-2-pyrrolidon und N-Methyl-ε-caprolactam;

—N,N-Dialkylamide von aliphatischen Monocarbonsäuren mit 1—3 C-Atomen in Säureteil, wie N,N-Dimethylformamid, N,N-Dimethylacetamid, N,N-Diäthylacetamid, N,N-Dimethylmethoxyacetamid;

—Pyridin und Pyridinbasen oder tertiäre Amine, vor allem Trialkyl- und Dialkylbenzylamine mit bevorzugt 1—4 C-Atomen in den Alkylteilen, z.B. Triäthylamin und Diäthylbenzylamin;

—Dialkylsulfoxide, wie Dimethyl- und Diäthylsulfoxid.

Bevorzugte Lösungsmittel für Kondensationsreaktionen sind cyclische Amide und N,N-Dialkylamide der vorerwähnten Art, besonders N-Methyl-2-pyrrolidon, N,N-Dimethylformamid und N,N-Dimethylacetamid. Für Additionsreaktionen werden cyclische Aether und cyclische Ketone, vor allem Tetrahydrofuran und Cyclohexanon, sowie Pyridin bevorzugt.

Man kann der Reaktionslösung auch Katalysatoren zusetzen, welche die gewünschte Verknüpfung begünstigen. So ist z.B. für die Bildung von Estern der Zusatz tertiärer Amine, wie Triäthylamin oder Pyridin, quaternärer Ammoniumsalze, wie Tetraalkylammoniumchloride mit je 1—4 bevorzugt 1 oder 2 C-Atomen in den Alkylgruppen, p-Toluolsulfonsäure oder konzentrierte Schwefelsäure günstig.

Nach der Umsetzung lassen sich die mit den definitionsgemässen tricyclischen Imidylgruppen modifizierten Polymere durch Zugabe eines wenig polaren Lösungsmittels ausfällen. Beispiele solcher wenig polarer Lösungsmittel sind Dialkyläther mit je 2—4 C-Atomen in den Alkylteilen, wie Diäthyläther und Di-n-propyläther, Alkohole mit bis zu 6 C-Atomen, wie Methanol, Aethanol, Isopropanol, Butanole und Pentanole, aliphatische cycloaliphatische oder aromatische Kohlenwasserstoffe, wie n-Pentan, n-Hexan, Cyclohexan, Benzol und Toluol.

Die Homopolymerisation von Verbindungen der Formel II, worin X eine polymerisierbare Gruppe darstellt oder eine polymerisierbare Gruppierung enthält, sowie deren Copolymerisation mit anderen äthylenisch ungesättigten Monomeren, z.B. solchen der Formel XVIa, können ebenfalls auf an sich bekannte Weise vorgenommen werden, z.B. in Gegenwart üblicher kationischer und anionischer Initiatoren. Bevorzugt ist die radikalische Polymerisation. Dabei verwendet man zweckmässig etwa 0,01 bis 5 Gew.%, vorzugsweise 0,01 bis 1,5 Gew.%, bezogen auf das Gesamtgewicht der Monomeren, an sich bekannter Radikalinitiatoren, wie anorganische oder organische Peroxide oder Azoverbindungen, z.B. Wasserstoffperoxid, Kaliumperoxidisulfat, tert-Butylhydroperoxid, Di-tert-butylperoxid, Peressigsäure, Benzoylperoxid, Diacylperoxide, Cumolhydroperoxid, tert-Butylperbenzoat, tert-Alkylperoxidcarbonate und $\alpha,\alpha'$-Azoisobutyronitril. Die Reaktionstemperaturen für die radikalische Polymerisation liegen im allgemeinen zwischen etwa 30 und 100°C. Die radikalische Polymerisation kann aber auch in der Kälte durchgeführt werden, wozu man auch Redoxsysteme in den oben genannten Konzentrationen verwenden kann, beispielsweise Gemische aus Peroxiden, wie Wasserstoffperoxid, und einem Reduktionsmittel, wie zweiwertige Eisenionen.

Die Polymerisation kann in homogener Phase, z.B. in Substanz (Blockpolymerisation) oder in Lösung oder in heterogener Phase, d.h. als Fällungspolymerisation, Emulsions- oder Suspensionspolymerisation, erfolgen. Bevorzugt ist die Polymerisation in Lösung.

Geeignete Lösungsmittel sind solche der bei der Kondensations- bzw. Additionsreaktion erwähnten Art sowie:

—halogenierte aromatische Kohlenwasserstoffe, wie Chlorbenzol und Dichlorbenzole;

—chlorierte aliphatische Kohlenwasserstoffe, wie Methylenchlorid, Chloroform, Tetrachloräthan und Tetrachloräthylen;

—Alkylester von aliphatischen Monocarbonsäuren mit insgesamt 2—6 C-Atomen, wie Ameisen- oder Essigsäuremethyl-, -äthyl- und -n-butylester;

—Aethylenglykoldialkyläther mit 1—4 C-Atomen in den Alkylteilen, wie Aethylenglykoldimethyl-, -diäthyl- und -di-n-butyläther.

Es können auch Gemische derartiger Lösungsmittel verwendet werden.

Nach beendeter Umsetzung kann das Polymere durch Eingiessen in geeignete organische Lösungsmittel, z.B. aliphatische Kohlenwasserstoffe, Alkohole oder Dialkyläther, wie n-Pentan, n-Hexan, Methanol, Aethanol und Diäthyläther, ausgefällt werden.

Die für die Herstellung der erfindungsgemässen Polymeren zu verwenden Verbindungen der Formel II und III, worin A $—CH_2—$, $—CH_2CH_2—$ oder $—OCH_2—$ mit an den aromatischen Ring gebundenem Sauerstoffatom und E Wasserstoff bedeuten und Y, n, X und X' die angegebene Bedeutung haben können dadurch hergestellt werden, dass man eine Verbindung der Formel XX

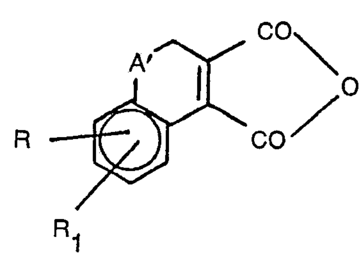

(XX)

worin A' $-CH_2-$, $-CH_2CH_2-$ oder $-OCH_2-$ mit an den aromatischen Ring gebundenem Sauerstoffatom bedeutet und R und $R_1$ die unter Formel I angegebene Bedeutung haben, mit einer Verbindung der Formel XXI

$$H_2N-(Y)_{n-1}-X'' \quad \text{(XXI)}$$

umsetzt, worin Y und n die unter Formel II angegebene Bedeutung haben, X'', bie n = 1, eine Gruppe der Formel

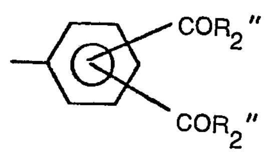

und bei n = 2, —OH, $-NH_2$, —NH-Alkyl mit 1—4 C-Atomen, —COOH, —SH, —O-Alkenyl mit 2—4 C-Atomen im Alkenylteil bedeutet, die $-COR_2''$-Gruppen in meta- oder para-Stellung zueinander an den Benzolring gebunden sind und die $R_2''$ je —OH, —Cl, Alkoxy mit 1—4 C-Atomen oder Phenoxy darstellen oder die $-COR_2''$-Gruppen in ortho-Stellung zueinander an den Benzolring gebunden sind und die $R_2''$ zusammen —O— bilden und $M^+$ die unter Formel II angegebene Bedeutung hat, gegebenenfalls intermediär gebildete Amidcarbonsäuren cyclisiert und das Imid gegebenenfalls anschliessend in eine Verbindung der Formel II oder III überführt, worin X'' eine von X bzw. X' verschiedene Bedeutung hat.

Verbindungen der Formel II und III, worin A —O— und E $-CH_3$ bedeuten und R, $R_1$, Y und n die unter Formel I bzw. II angegebene Bedeutung haben, können dadurch erhalten werden, dass man eine Verbindung der Formel II oder III mit $A = -OCH_2-$ thermisch oder in Gegenwart eines basischen Katalysators in eine Verbindung der Formel II oder III mit A = —O— und $E = -CH_3$ umlagert.

Die Verbindungen der Formel XXI und die Verbindungen der Formel XX, worin A' $-CH_2-$ bedeutet, sind bekannt oder können nach an sich bekannten Methoden hergestellt werden. Verbindungen der Formel XX, worin A' $-CH_2CH_2-$ oder $-OCH_2-$ darstellt, können z.B. durch Umsetzung von gegebenenfalls ringsubstituierten 5-Phenylvaleriansäureestern bzw. Phenoxybuttersäureestern mit einem Oxalsäurediester zum 3-Phenylpropyl- bzw. 2-Phenoxyäthyl-oxalessigsäurediester und Behandeln des Reaktionsproduktes mit einer starken Säure, wie konzentrierte Schwefelsäure, hergestellt werden.

Die Umsetzung der Amine der Formel XXI mit den Anhydriden der Formel XX kann in der Schmelze durch Erhitzen der Reaktionspartner auf Temperaturen bis etwa 250°C oder aber in wässrigem, wässrig-organischem oder organischem Medium vorgenommen werden. Als organische Lösungsmittel kommen vor allem aprotische organische Lösungsmittel in Betracht, z.B. gegebenenfalls halogenierte aliphatische oder aromatische Kohlenwasserstoffe, cyclische Aether, cyclische Amide, N,N-Dialkylamide von aliphatischen Monocarbonsäuren oder Dialkylsulfoxide der vorerwähnten Art.

Allfällig intermediär gebildete Amidcarbonsäuren können auf an sich bekannte Weise chemisch oder thermisch zu den Imiden cyclisiert werden.

Die Ueberführung in Verbindungen der Formel II oder III mit von X'' verschiedener Bedeutung von X bzw. X' kann ebenfalls auf an sich bekannte Weise vorgenommen werden, z.B.:

*X = —NH—CO-Alkenyl (n = 1 oder 2):* durch Umsetzen von Reaktionsprodukten mit n = 1 oder 2 und $X'' = -NH_2$ mit Alkenyl-COCl.

*X bzw. X' = Phthalsäureanhydridrest oder ein ortho-ständiges $R_2 = -OH$ und das andere =*

$$-O(CH_2)_qOCO-\underset{\displaystyle Q_1}{\underset{|}{C}}=CH_2:$$

durch Cyclisieren entsprechender Verbindungen, worin X'' = Phthalsäurerest und gegebenenfalls anschliessende Umsetzung mit Alkoholen

$$HO(CH_2)_qOCO-\underset{\displaystyle Q_1}{\underset{|}{C}}=CH_2$$

*X' = —COCl oder $R_2 = -Cl$:* durch Behandeln der freien Säuren mit einem Chlorierungsmittel, wie Thionylchlorid Oxalylchlorid oder Phosgen

*X = CO—O—Alkenyl:* durch Umsetzen der entsprechenden freien Säuren oder der Säurechloride mit ungesättigten Estern oder Alkoholen in Gegenwart von Säuren oder Basen.

*X = —O—CO-Alkenyl oder —S—CO-Alkenyl:* durch Umsetzen von Verbindungen der Formel III mit

X' = —OH oder —SH mit entsprechenden ungesättigten Säuren, Säurechloriden oder Estern.

Die erfindungsgemässen Polymeren lassen sich unter der Einwirkung von Licht vernetzen und eignen sich beispielsweise zur Herstellung von Druckplatten für das Offsetdruckverfahren, zur Herstellung von Photooffset-Lacken, für die unkonventionelle Photographie, zum Anfärben von nach den Belichten und Entwickeln schlecht sichtbaren Polymerbildern mit geeigneten Farbstoffen, wie öllösliche Farbstoffe oder, wenn das Polymere saure Gruppen, wie Carbonsäure- oder Sulfonsäuregruppen aufweist, kationische Farbstoffe. Die erfindungsgemässen Polymeren finden insbesondere Anwendung als sogenannte Photoresist zur Herstelluung von gedruckten Schaltungen nach an sich bekannten Methoden. Dabei wird die mit der lichtempfindlichen Schicht versehene Seite der Leiterplatte durch ein das Leiterbild aufweisendes Dianegativ belichtet und dann entwickelt, worauf man die unbelichteten Stellen der Schicht durch Entwicklungsflüssigkeit herausholt. Die Belichtung kann mit Sonnenlicht, Kohlelichtbogen oder Xenonlampen durchgeführt werden. Mit Vorteil wird die Belichtung mit Quecksilberhochdrucklampen vorgenommen. Die Trägermaterialien können nach an sich üblichen Techniken mit den lichtempfindlichen Polymeren beschichtet werden, z.B. durch Tauchverfahren, Sprüh-, Schleuder-, Kaskaden- oder Vorhangguss oder sogenanntes "rollercoating."

Beispiel 1

100 g Copolymerisat aus Methylvinyläther und Maleinsäureanhydrid (1:1; Anhydridgehalt = 0,64 Mol, Durchschnittsmolekulargewicht 740 000), 77,8 g (0,32 Mol) N-(2'-Hydroxyäthyl)-3,4-dihydronaphthalin-1,2-dicarbonsäureimid und 10 ml Pyridin werden in 1820 ml getrocknetem Tetrahydrofuran gelöst. Das Reaktionsgemisch wird unter Rühren während 72 Stunden bei 80°C gehalten. Nach dem Abkühlen auf Raumtemperatur (20—25°C) wird die klare Lösung in 5 Liter Diäthyläther ausgefällt und am Vakuum getrocknet. Man erhält 141,0 g (79,3% d.Th.) eines weissen Polymers. Für die Elementaranalyse wird eine Probe des Polymers in 0,1 N HCl ausgefällt.

Elementaranalyse:

gefunden C 55.3% H 5,9% N 2,23%.

Auf analoge Weise werden unter Verwendung der in der folgenden Tabelle I angegebenen Komponenten weitere Polymere hergestellt.

TABELLE I

| Beispiel Nr. | Imid | Polymer | g Imid | g Polymer |
|---|---|---|---|---|
| 2 | N-(2'-Hydroxyäthyl)-6,7-dihyro-5H-benzocyclohepten-8,9-dicarbonsäureimid | 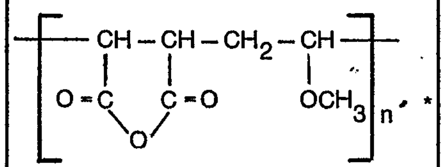 | 82,3 | 100 |
| 3 | N-(2'-Hydroxyäthyl)-2-methyl-2H-chromen-3,4-dicarbonsäureimid | do. | 82,9 | 100 |
| 4 | N-(2'-Hydroxyäthyl)-2,3-dihydro-1-benzoxepin-4,5-dicarbonsäureimid | do. | 78,4 | 100 |
| 5 | N-(3'-Hydroxy-2',2'-dimethylpropyl)-3,4-dihydronaphthalin-1,2-dicarbonsäureimid | do. | 87,4 | 100 |
| 6 | N-(3'-Hydroxy-2',2'-dimethylpropyl)-6,7-dihydro-5H-benzocyclohepten-8,9-dicarbonsäureimid | do. | 95,6 | 100 |

* n' >>^

Beispiel 7

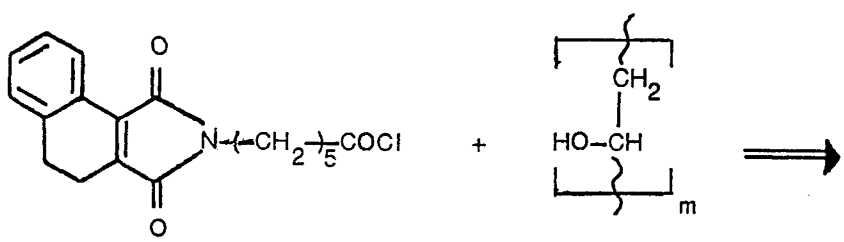

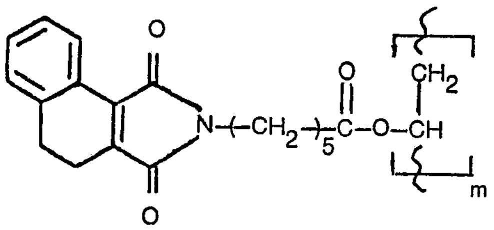

"m" berechnet sich aus dem Molekulargewicht

4,1 g Polyvinylalkohol mit einem mittleren Molekulargewicht von ca. 13'000 und einem Restacetatgehalt von 12% werden zusammen mit 36,6 ml wasserfreiem Pyridin während 15 h auf 100°C erhitzt. Danach werden weitere 36,6 ml wasserfreies Pyridin zugefügt und die Lösung stark auf 50°C abgekühlt. Nun werden 0,59 g Diazabicyclooctan, gelöst in 3,7 ml wasserfreiem Pyridin, zugegeben, direkt anschliessend werden 12,9 g (0,038 Mol) N-(Capronsäurechlorid)-3,4-dihydronaphthalin-1,2-dicarbonsäureimid portionenweise zugefügt und während 4 Stunden bei 50°C gerührt. Nach Abkühlen auf Raumtemperatur werden 90 ml Aceton zugefügt. Das ausgefallene Pyridiniumhydrochlorid wird abfiltriert und das Filtrat in 2 Liter Wasser ausgefällt. Nach Trocknen über $P_2O_5$ erhält man 10 g eines bräunlichen Polymers (75,8% d.Th.,), welches eine Viskosität, $\eta$ inherent (25°C, DMF), von 0,3 dl/g aufweist.

Beispiel 8

31,1 g (0,1 Mol) N-(2'-Methacryloyloxyäthyl)-3,4-dihydronaphthalin-1,2-dicarbonsäureimid werden zusammen mit 0,31 g $\alpha,\alpha'$-Azoisobutyronitril in 140 ml Tetrahydrofuran gelöst. Das Reaktionsgemisch wird unter Stickstoffatmosphäre und ständigem Umrühren bei leichtem Rückfluss (ca. 80°C) während 6 Stunden polymerisiert. Nach beendeter Reaktion wird auf Raumtemperatur abgekühlt, und das Polymere wird durch Eintropfen der Reaktionslösung in 2 Liter n-Hexan ausgefällt. Man erhält 24,4 g (78,5% d.Th.) eines weissen Pulvers; inhärente Viskosität: 0,15 dl/g (0,5 Gew.%, gemessen bei 20°C in N,N-Dimethylformamid).

Beispiel 9 bis 14

Unter analogen Reaktionsbedingungen wie in Beispiel 8 werden weitere lichtempfindliche Polymere hergestellt, deren Herstellung und Viskosität in Chloroform in der Tabelle II veranschaulicht werden.

TABELLE II (Analog Beispiel 7 im Text)

| Bsp. | Polymerzusammensetzung | | | | Ausbeute | $\eta$ grenz in $CHCl_3$ |
|---|---|---|---|---|---|---|
| | Monomer I | Mol % | Monomer II | Mol % | | |
| 9 | N-(2-Methacryloyloxyäthyl-3,4-dihydronaphtalin-1,2-dicarbonsäureimid | 100 | – | – | 70 % | 0,075 dl /g * |
| 10 | ,, | 70 | N-Vinyl-2-pyrolidon | 30 | 16 % | 0,12 dl /g |
| 11 | ,, | 60 | Acrylsäure-2-äthylhexylester | 40 | 18 % | 0,2 dl /g |
| 12 | ,, | 50 | Methacrylsäuremethylester | 50 | 38 % | 0,18 dl /g |
| 13 | ,, | 60 | 4-Vinylpyridin | 40 | 9 % | 0,08 dl /g |
| 14 | N-(2-Acryloyloxyäthyl-3,4'-dihydronaphtalin-1,2-dicarbonsäureimid | 100 | – | – | 40 % | 0,06 dl /g |

* Tg 126°C
$\overline{M}w$ 36'000

Beispiel 15

2,5 g (0,00662 Mol) N-(3-Isophtaloyl-dicarbonsäure)-6,7-dihydrobenzocyclohepten-8,9-dicarbonsäureimid und 1,79 g (0,00729 Mol) 1,3-Diglycidyl-5,5-dimethylhydantoin werden in 85 ml Cyclohexanon gelöst und mit 1 Kristall Tetrabutylammoniumchlorid versetzt. Die Lösung wird 2 Stunden bei 110°C gerührt. Die gelbe, leicht viskose Lösung kann direkt zur Beschichtung von Kupferplatten verwendet werden.

Beispiel 16

In einem 750 ml Sulfierkolben werden 7,3 g (0,0639 Mol) 2,5-Dimethylpiperazin und 18 ml Triäthylamin in 100 ml trockenem Chlorform gelöst und auf —5°C gekühlt. Bei dieser Temperatur wird eine Suspension von 8 g (0,0193 Mol) N-(3-Isophthaloyldicarbonsäurechlorid)-6,7-dihydrobenzocyclohepten-8,9-dicarbonsäureimid und 10,78 g (0,045 Mol) Sebacinsäuredichlorid in 100 ml Chloroform bei —5°C zugetropft. Bei Raumtemperatur wird 3 Stunden ausgerührt und die leicht viskose Lösung mit 1500 ml Petroläther ausgefällt. Man erhält 13 g beiges Polymer.

Beispiel 17

Dieses Beispiel betrifft Abbildungen, die durch Photovernetzung von erfindungsgemässen Polymeren erzeugt und durch Anfärben besser sichtbar gemacht werden, sowie die Ermittlung der relativen Empfindlichkeit der so erhaltenen Abbildungen. Belichtet wird mit einer 400 Watt Quecksilberdampf-Hochdrucklampe in einem Abstand von 40 cm zum Vakuumtisch. Als Vorlage dient ein Stouffer-Stufenkeil wie beschrieben in "Photoresist, Material and Processes" W. S. De Forest, S. 110 (McGraw-Hill Book Company, New York, 1975).

Beschichtung: Das lichtvernetzbare Polymere wird durch Aufschleudern mit 1000 Touren/Minute aus einer 5%igen Lösung in N,N-dimethylformamid auf Aluminiumplatten (ca. 0,3 mm) aufgetragen.

Entwicklung: 3 Sekunden in Tetrahydrofuran; 30 Sekunden in 3%iger $NaHCO_3 . H_2O$.

Einfärbung: Das bildmässig vernetzte Polymere lässt sich anschliessend leicht mit einem kationischen Farbstoff anfärben, z.B. durch 30 Sekunden Einfärben in einer 5%igen wässrigen Lösung des Farbstoffs der Formel

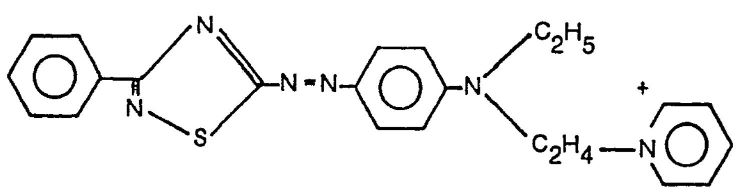

.

In der folgenden Tabelle III ist die Anzahl angefärbter Stufen im Stufenkeil bei entsprechender Belichtungszeit angegeben.

TABELLE III

| Polymer gemass | Belichtungszeit | Anzahl angefärbter Stufen im Stufenkeil |
|---|---|---|
| Beispiel 1 | 6 Minuten | 9 |
| | 3 Minuten | 7 |
| | 1 Minute | 5 |
| Beispiel 2 | 9 Minuten | 5 |
| | 6 Minuten | 2 |
| | 3 Minuten | 1 |
| Beispiel 3 | 9 Minuten | 5 |
| | 6 Minuten | 3 |
| | 3 Minuten | 1 |
| Beispiel 4 | 9 Minuten | 7 |
| | 6 Minuten | 5 |
| | 3 Minuten | 3 |

Beispiel 18

Dieses Beispiel betrifft Abbildungen, die durch Photovernetzung von erfindungsgemässen Polymeren auf Kupferbeschichteten Platten hergestellt werden. Als Vorlage dient ein Stouffer-Stufenkeil, belichtet wird mit einer 400 W-Quecksilberdampf-Hochdrucklampe in einem Abstand von 40 cm zum Vakuumtisch. Nach der Belichtung wird das Bild in einem Chloroform-Bad entwickelt und die nun blanken Kupferteile durch Anätzen in $FeCl_3$-Lsg. besser sichtbar gemacht.

—Beschichtung: Das Polymer wird durch Aufschleudern mit 1000 T/Min aus einer 5%-igen Lösung in N,N-Dimethylformamid auf kupferbeschichteten Epoxidplatten aufgetragen (Schichtdicke der trockenen Polymere ca. 1—3 $\mu$m).

In der folgenden Tabelle IV ist die Anzahl abgebildeter Stufen des Stufenkeils bei der Entsprechenden Belichtungszeit angegeben.

TABELLE IV

| Beispiel | Belichtungszeit | Anzahl abgebildeter Stufen |
|---|---|---|
| 7 | 3′<br>6′ | 2<br>3 |
| 9 | 3′<br>6′ | 5<br>6 |
| 10 | 12 | 5 |
| 11 | 3′<br>6′ | 4<br>5 |
| 12 | 6′ | 5 |
| 14 | 6′ | 4 |

*Beispiele für die Herstellung von Ausgangsprodukten der Formel II oder III für die durch Licht vernetzbaren Polymeren*

Beispiel a

*N-(2'-Hydroxyäthyl)-3,4-dihydronaphthalin-1,2-dicarbonsäureimid*

Eine Lösung von 70 g (0,35 Mol) 3,4-Dihydronaphthalin-1,2-dicarbonsäureanhydrid [hergestellt nach Org. Syntheses, Col., Vol. 2, 194(1943)] und 23,5 g (0,385 Mol) Aethanolamin in 1,7 Liter Eisessig wird 24 Stunden unter Rückfluss gehalten. Danach wird der Eisessig destillativ entfernt, der Rückstand wird in 2 Liter absolutem Aethanol gelöst, 50 g eines Ionenaustauschers ("Dowex 50 W" der Fa. Fluka AG) werden zugegeben, und die Suspension wird 24 Stunden unter Rückfluss gehalten. Anschliessend wird der Ionenaustauscher abfiltriert, der Aethanol wird abdestilliert, und der Rückstand wird aus Diäthyläther/Aethanol umkristallisiert. Man erhält 61,8 g (73% d.Th.) N-(2'-Hydroxyäthyl)-3,4-dihydronaphthalin-1,2-dicarbonsäureimid Smp. 120,5—121°C.

Beispiel b

*N-(2'-Hydroxyäthyl)-6,7-dihydro-5H-benzocyclohepten-8,9-dicarbonsäureimid*

1. Zu einer Lösung von 15 g (0,07 Mol) 6,7-Dihydro-5H-benzocyclohepten-8,9-dicarbonsäureanhydrid in 150 ml Toluol gibt man bei Raumtemperatur (20—25°C) 4,5 g Aethanolamin zu.Während 2 Stunden wird unter Rückfluss gekocht, und das gebildete Wasser wird kontinuierlich mit einem Wasserabscheider entfernt. Nachher wird das Toluol destillativ entfernt, und der Rückstand wird aus Aethanol umkristallisiert. Man erhält 1,4 g (82% d.Th.) gelber Kristalle mit Smp. 115°C.

In den folgenden Abschnitten 2, 3 und 4 wird die Herstellung des 6,7-Dihydro-5H-benzocyclohepten-8,9-dicarbonsäureanhydrids beschrieben:

2. *5-Phenylvaleriansäureäthylester*

250 g (1,4 Mol) 5-Phenylvaleriansäure löst man in 450 ml absolutem Aethanol. Zur klaren, farblosen Lösung gibt man 114 ml konzentrierter Schwefelsäure und erhitzt das Reaktionsgemisch während 48 Stunden am Rückfluss. Das zunächst zweiphasige Reaktionsgut wird annähernd homogen und trennt sich beim Kühlen wieder in zwei Phasen. Das kalte zweiphasige Reaktionsgut wird auf Diathyläther und ca. 1 kg Eis gegossen. Die Wasserphase wird noch zweimal ausgeäthert. Die Aetherphasen wäscht man zweimal mit 2N-Sodalösung und zweimal mit NaCl-Lösung. Die vereinigten Aetherphasen trocknet man über $MgSO_4$ und entfernt das Lösungsmittel am Rotationsverdampfer. Nach dem Trocknen im Hochvakuum bei Raumtemperatur erhält man 281,7 g eines farblosen Oels (97,5% d.Th.).

Das Rohprodukt wird weiterverwendet (vgl. Abschnitt 4).

3. *3-Phenylpropyl-oxalessigsäurediäthylester*

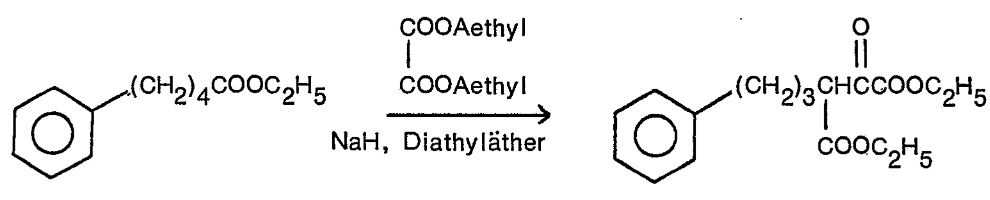


(*B*) (*C*)

Eine Suspension von ölfreiem Natriumhydrid in Diäthyläther, hergestellt durch zweimaliges Waschen von 71,8 g einer Natriumhydrid-Dispersion (55%ig in Oel) mit n-Pentan unter Stickstoff und mit 3 Liter absoluter Diäthyläther versetzt, werden zum Rückfluss gebracht. Zur siedenden Suspension gibt man tropfenweise ein Gemisch von 281,7 g (1,36 Mol) 5-Phenylvaleriansäureäthylester und 297 g (1,36 m + 50%) Oxalsäurediäthylester während ca. 6 Stunden. Das Reaktionsgut wird anschliessend während total 66 Stunden am Rückfluss gehalten. Im Dünnschichtchromatogramm ($CHCl_3$) ist neben sehr wenig Ausgangsmaterial ($R_F$ ca. 0,6) ein Hauptfleck mit $R_F$ ca. 0,5 vorhanden. Das Reaktionsgut giesst man nach dem Erkalten auf 500 g Eis und 1,05 Äquivalente HCl (=530 ml 2N HCl). Die Wasserphase extrahiert man mit Diäthyläther, trocknet den Diäthyläther über $MgSO_4$ und entfernt ihn im Vakuum. Nach dem Trocknen im Vakuum erhält man 520 g rötliches Oel, das noch Oxalester enthält. Das Rohprodukt wird direkt weiterverwendet.

4. *6,7-Dihydro-5H-benzocyclohepten-8,9-dicarbonsäureanhydrid*

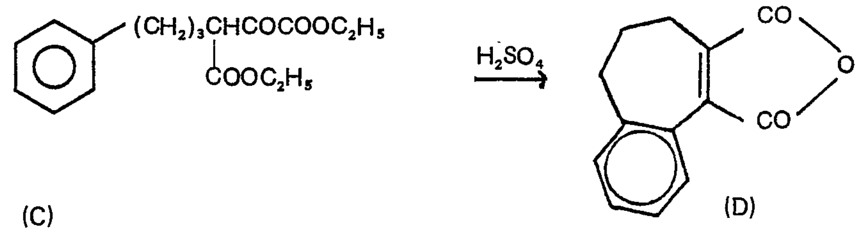


(C) (D)

240 ml 90%ige Schwefelsäure werden auf 0—5°C gekühlt. Bei dieser Temperatur tropft man innerhalb von ca. 15—20 Minuten 30 g des Esters *C* zu. Es entsteht eine dunkelgelbe bis rötliche Lösung. Das Reaktionsgut lässt man sodann auf Raumtemperatur auftauen und verfolgt den Fortgang der Reaktion mittels Dünnschichtchromatographie. Nach ca. 3 bis 4 Stunden ist kein Ausgangsmaterial mehr sichtbar. Dünnschichtchromatogramm ($CHCl_3$) Ausgangsmaterial: $R_F$ ca. 0,7; Reaktionsprodukt $R_F$ ca. 0,8.

Das Reaktionsgut giesst man auf 1,5 Liter Eis und genügend NaCl zur Sättigung der entstehenden Wasserphase (ca. 500 g). Unter heftigem Rühren scheidet sich ein weisser, kristalliner Niederschlag ab. Dieser wird abgenutscht, scharf abgesaugt, in Diäthyläther aufgenommen und von unlöslichen Bestandteilen abgetrennt. Die Aetherlösung wird über $MgSO_4$ getrocknet, am Rotationsverdampfer eingeengt und am Hockvakuum getrocknet.

1. Teil von Produkt *D*: Die Wasserphase wird mit Diäthyläther ausgezogen, der Diäthyläther wird mit NaCl-Lösung gewaschen, getrocknet und am Rotationsverdampfer entfernt.

2. Teil Produkt *D*: Auf Grund des Dünnschichtchromatogramms praktisch identisch mit dem ersten Teil. Die beiden Teile werden vereinigt und das Isopropanol umkristallisiert. Man erhält 10 g (47% d.Th.) der Verbindung *D* in Form schwach gelblicher Kristalle; Smp. 112—113°C.

Beispiel c

*n-(2'-Hydroxyäthyl)-2-methyl-2H-chromen-3,4-dicarbonsäureimid und N-(2'-Hydroxyäthyl)-2,3-dihydro-1-benzoxepin-4,5-dicarboximid*

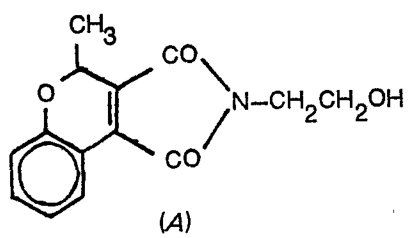

(*A*) und

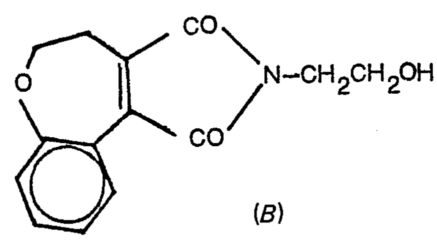

(*B*)

Eine Lösung von 48,65 g (0,2 Mol) 2,3-Dihydro-1-benzoxepin-4,5-dicarbonsäureanhydrid und 13,4 g (0,22 Mol) Aethanolamin in 1,5 Liter Eisessig wird 2 Tage unter Rückfluss gehalten. Danach wird der Eisessig abdestilliert, der Rückstand wird in 2 Liter absolutem Methanol gelöst, 70 g eines Ionenaustauschers ("Dowex 50 W" der Fa. Fluka AG) werden zugegeben, und die Suspension wird 2 Tage unter Rückfluss gehalten. Anschliessend wird der Ionenaustauscher abfiltriert, das Methanol wird destillativ entfernt, und der Rückstand wird an einer Kielselgelsäure (Fliessmittel Toluol/Aethylacetat im Volumenverhältnis 2:1) getrennt. Die erste Fraktion ($R_F$ ca. 0,3) enthält 9,3 g (18% d.Th.) N-(2'-Hydroxyäthyl)-2-methyl-2H-chromen-3,4-dicarbonsäureimid (Verbindung *A*) in Form gelber Kristalle (aus Methylenchlorid/n-Hexan umkristallisiert); Smp. 124°C.

Die zweite Fraktion ($R_F$ ca. 0,2) enthält 41,5 g (80% d.Th.) N-(2'-Hydroxyäthyl)-2,3-dihydro-1-benzoxepin-4,5-dicarbonsäureimid (Verbindung *B*); Smp. 136—137°C (aus $CH_2Cl_2$ n-Hexan umkristallisiert).

Das Ausgangsprodukt [2,4-Dihydro-1-benzoxepin-4,5-dicarbonsäureanhydrid] kann wie folgt hergestellt werden:

Zu einer Suspension von 5 g (0,104 Mol) einer 50%igen Natriumhydrid-dispersion in Mineralöl in 50 ml Diäthyläther tropft man unter Rühren bei einer Temperatur von 15°C eine Lösung von 22 g (0,15 Mol) Oxalsäurediäthylester in 100 ml Diäthyläther zu. Anschliessend lässt man zwei Stunden bei Raumtemperatur rühren. Dazu lässt man eine Lösung von 21 g (0,10 Mol) Phenoxybuttersäureäthylester [hergestellt nach Powell und Adams, J.Amer.Chem.Soc.,*42*, 652(1920)] in 100 ml Diäthyläther zulaufen und kocht anschliessend während 10 Stunden unter Rückfluss. Nach dem Abkühlen fügt man 1 ml Aethanol hinzu und giesst dann auf eine Mischung von 100 g Eis und 150 ml Wasser. Die wässrige Phase wird mit 2N Salzsäure auf pH 3 gestellt. Im Scheidetrichter werden die

Schichten getrennt, und die wässrige Phase wird nochmals mit 250 ml Diäthyläther extrahiert. Die vereinigten Aetherextrakte werden mit 100 ml Wasser gewaschen, dann über Magnesiumsulfat getrocknet und anschliessend im Wasserstrahlvakuum eingedampft. Als Rückstand verbleiben 30,8 g (100% d.Th.) roher 2-Phenoxyäthyloxalessigsäure-diäthylester in Form eines schwach rötlichen Oels.

Zu einer eisgekühlten Mischung von 225 ml konz. Schwefelsäure und 25 ml Wasser lässt man unter Rühren 30,8 g (0,10 Mol) rohen 2-Phenoxyäthyloxalessigsäure-diäthylester innerhalb von 15 Minuten bei einer Temperatur von 5—10°C zutropfen. Anschliessend lässt man die Reaktionstemperatur auf 15°C ansteigen und rührt ein Stunde bei dieser Temperatur. Hierauf giesst man das Reaktionsgemisch unter Rühren zu einer Mischung von 1000 g Eis und 1500 ml Wasser, wobei das 2,3-Dihydro-1-benzoxepin-4,5-dicarbonsäureanhydrid ausfällt. Dieses wird abgenutscht und aus Isopropanol umkristallisiert. Man erhält 14,0 g 2,3-Dihydro-1-benzoxepin-4,5-dicarbonsäureanhydrid (64,7% d.Th.) vom Smp. 142—143°C.

Beispiel d

*N-(3'-Hydroxy-2',2'-dimethylpropyl)-3,4-dihydronaphthalin-1,2-dicarbonsäureimid*

20,0 g (0,1 Mol) 3,4-Dihydronaphthalin-1,2-dicarbonsäureimid und 10,3 g (0,1 Mol) 2,2-Dimethyl-3-aminopropanol werden in 60 ml Toluol gelöst und während 2 Stunden am Rückfluss gekocht, wobei das entstehende Wasser durch einen Wasserabscheider abgetrennt wird. Nach beendeter Reaktion wird am Vakuum bei 60°C zur Trockne eingeengt. Der Rückstand wird aus Aethanol umkristallisiert. Man erhält 25,1 g (87,9% d.Th.) N-(3'-Hydroxy-2',2'-dimethylpropyl)-3,4-dihydronaphthalin-1,2-dicarbonsäureimid.

Beispiel e

*N-(3'-Hydroxy-2',2'-dimethylpropyl)-6,7-dihydro-5H-benzocyclohepten-8,9-dicarbonsäureimid*

21,4 g (0,1 Mol) 6,7-Dihydro-5H-benzocyclohepten-8,9-dicarbonsäureanhydrid und 10,3 g (0,1 Mol) 2,2-Dimethyl-3-aminopropanol werden in 60 ml Toluol gelöst und während 1 Stunde am Rückfluss gekocht, wobei das entstehende Wasser durch einen nachgeschalteten Wasserabscheider abgetrennt wird. Nach dem Abkühlen auf Raumtemperatur werden die ausgefallenen Kristalle abfiltriert. Man erhält 28,9 g (96,6% d.Th.)N-(3'-Hydroxy-2',2'-dimethylpropyl)-6,7-dihydro-5H-benzocyclohepten-8,9-dicarbonsäureimid.

Beispiel f

*N-(2'-Methacryloyloxyäthyl)-3,4-dihydronaphthalin-1,2-dicarbonsäureimid*

24,3 g (0,1 Mol) N-(2'-Hydroxyäthyl)-3,4-dihydronaphthalin-1,2-dicarbonsäureimid, 12,9 g (0,15 Mol) Methacrylsäure, 1,6 ml konz. Schwefelsäure und 1,0 g 2,6-Di-tert-butyl-p-kresol werden in Toluol gelöst und während 2 Stunden am Rückfluss gekocht, wobei das entstehende Wasser durch einen nachgeschalteten Wasserabscheider abgetrennt wird. Anschliessend wird auf Raumtemperatur abgekühlt, die Reaktionslösung wird mit 5,52 g (0,075 Mol) Calciumhydroxid versetzt und während 5 Minuten ausgerührt. Nach dem Abfiltrieren wird das Filtrat am Vakuum bei 60°C zur Trockne eingeengt. Man erhält 28,8 (95,7% d.Th.) N-(2'-Methacryloyloxyäthyl)-3,4-dihydronaphthalin-1,2-dicarbonsäureimid.

Beispiel g

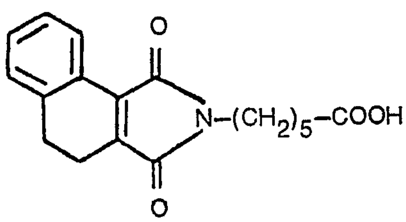

Eine Lösung von 20 g (0,1 Mol) 3,4-Dihydronaphthalin-1,2-dicarbonsäureanhydrid und 13,1 g (0,1 Mol) 6-Aminocapronsäure in 130 ml Essigsäure wird 6 Std. am Rückfluss gekocht. Die Reaktionslösung wird eingedampft. Das gelbe feste Produkt mit einem Fp. von 109—111°C wird aus 100 ml Tetrachlorkohlenstoff umkristallisiert.

Ausbeute: 23,9 g (76,2% d.Th.) Fp. 108—111°C; gelbe Kristalle.

Analyse:

| | | | |
|---|---|---|---|
| berechnet | C 69,00% | H 6,11% | N 4,47% |
| gefunden | C 68,78% | H 6,12% | N 4,69% |

NMR-Spektrum (DMSO—$D_6$): = 7,9 [1H]; 7,15 [3H]; 3,40 [2H, t]; 3,00 [2H, t]; 2,60 [2H, t]; 2,20 [2H, t]; 1,8—1,1 [6H, Mp].

Beispiel h

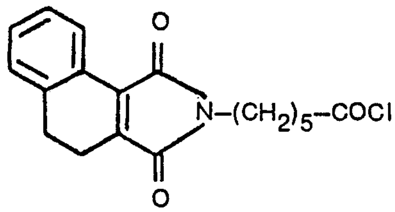

2 g (0,0062 Mol) des gemäss Beispiel g) erhaltenen N-(capronsäure)-3,4-dihydronaphthalin-1,2-dicarboximids und 0,51 ml (0,007 Mol) Thionylchlorid werden in 10 ml Dichlormethan gelöst und 24 Std. bei Raumtemperatur gerührt. Danach wird für 3 Std. zum Rückfluss erhitzt und danach zur Trockne eingedampft. Man erhält 2 g (94,4% d, Th) öliges Produkt, welches nach 24 Std. kristallisiert. Fp. 65—67°C.

| Analyse: | | | | |
|---|---|---|---|---|
| berechnet | C 65,16% | H 5,47% | N, 4,22% | Cl 10,69% |
| gefunden | C 65,34% | H 5,54% | N 4,31% | Cl 9,51%. |

Beispiel i

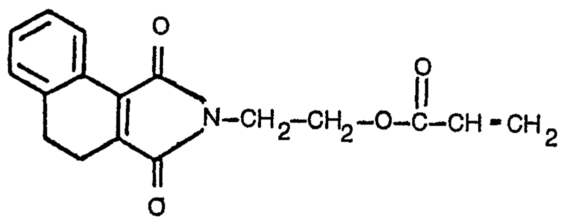

Eine Lösung von 60,82 g N-(2'-Hydroxyäthyl)-3,4-dihydronaphthalin-1,2-dicarbonsäureimid, 24,51 g (0,34 Mol) Acrylsäure und 5 ml $H_2SO_4$ chem. rein in 240 ml Toluol werden unter Zusatz von 1,2 g Cu-II-acetat 1½ Std. am Rückfluss gekocht, wobei das entstehende Wasser (4,5 ml) durch einen Wasserabscheider abgetrennt wird.

Die auf Raumtemperatur abgekühlte Lösung wird mit 300 ml 8%ige $NaHCO_3$-Lösung neutralisiert. Die wässrige Phase wird mit 2 x 400 ml Toluol extrahiert. Die organische Phase wird mit 100 ml Wasser gewaschen, getrocknet und eingedampft.

Ausbeute: 53,3 g = 71,65%, Fp. 86—89°C.

| Analyse: | | | |
|---|---|---|---|
| berechnet | C 68,68% | H 5,09% | N 4,71% |
| gefunden | C 68,36% | H 5,1% | N 4,74%. |

Beispiel j

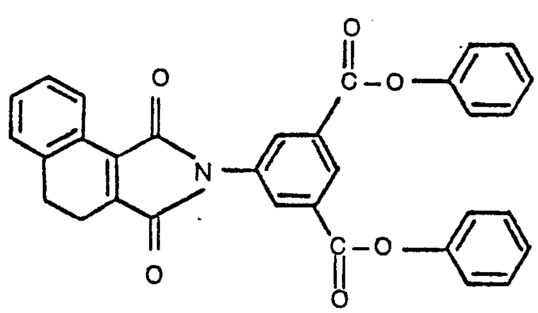

9,5 (0,100 Mol) Phenol werden in 500 ml wasserfreiem Toluol gelöst und zum Rückfluss erhitzt. 55 ml Toluol werden abdestilliert (Trocknung des Phenols) und auf Raumtemperatur abgekühlt. Bei Raumtemperatur werden 20 g (0,05 Mol) N-(4'-Isophthalsäuredichlorid)-3,4-dihydronaphthalin-1,2-dicarbonimids und 10,36 g (Triäthylamin zugegeben und 50 Std. bei Raumtemperatur gerührt. Die starke Suspension wird mit 200 ml Toluol verdünnt und genutscht. Das gelbe Filtrat wird eingedampft und aus

70 ml Aethylenglycolmonomethyläther umkristallisiert.

Ausbeute: 9 g = 35% d.Th., Fp. 205—208°C.

Analyse:

| | | | |
|---|---|---|---|
| berechnet | C 74,56% | H 4,11% | N 2,72% |
| gefunden | C 74,41% | H 3,95% | N 2,78%. |

Beispiel k

16,25 g (0,077 Mol) 3-Aminoisophthalsäure-di-Na-Salz, 150 ml Wasser, 150 ml Dimethylacetamid und 16,48 g (0,077 Mol) 6,7-Dihydro-5H-benzocyclohepten-8,9-dicarbonsäureanhydrid werden unter Rühren auf 100° erwärmt. Die klare Lösung wird 1 Stunde bei 100° gerührt. Nach dem Abkühlen auf 80° werden 85 ml 2n HCl Lösung zugetropft. Die auf Raumtemperatur gekühlte gelbe Suspension wird abgenutscht und das Nutschgut mit 100 ml kaltem Wasser gewaschen und 12 Stunden im Vakuum bei 100° getrocknet. Man erhält 28 g (96,7% d.Th.) N-(3-Isophthaloyl-dicarbonsäure)-6,7-dihydrobenzocyclohepten-8,9-dicarbonsäureimid mit der folgenden Elementaranalyse für die Summenformel $C_{21}H_{15}NO_6$

| | | | |
|---|---|---|---|
| berechnet | C 66,84% | H 4,01% | N 3,71% |
| gefunden | C 65,8% | H 3,97% | N 3,60%. |

Beispiel l

5 g (0,013 Mol) N-(3-Isophthaloyldicarbonsäure)-6,7-dihydrobenzocyclohepten-8,9-dicarbonsäureimid, 2 Tropfen Dimethylformamid und 26 ml Thionylchlorid werden 30 Minuten rückflussiert. Die rote Lösung wird eingedampft und das rote kristalline Produkt aus 30 ml trockenem Toluol umkristallisiert. Man erhält 2,4 g (43,7% d.Th.) N-(3-Isophthaloyldicarbonsäurechlorid)-6,7-dihydrobenzocyclohepten-8,9-dicarbonsäureimid mit einem Fp. von 178—181° und folgender Elementaranalyse berechnet für die Summenformel $C_{21}H_{13}NO_4Cl_2$

| | | | | |
|---|---|---|---|---|
| berechnet | C 60,89% | H 3,17% | N 3,38% | Cl 17,12% |
| gefunden | C 60,75% | H 3,21% | N 3,59% | Cl 16,9%. |

**Patentansprüche**

1. Ein unter der Einwirkung von Licht vernetzbares, Polymeres, dessen Durchschnittsmolekulargewicht mindestens 1000 beträgt und die seitenständige Imidylgruppen der Formel I

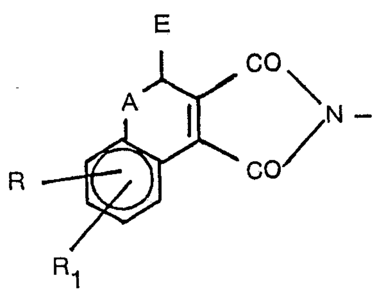

(I)

aufweist, worin

R und $R_1$ unabhängig voneinander Wasserstoff, Halogen, Alkyl mit 1—4 C-Atomen oder Methoxy,

A —$CH_2$—, —$CH_2CH_2$— oder —$OCH_2$— mit an den aromatischen Ring gebundenem Sauerstoffatom und

E Wasserstoff

oder

A —O— und

E —$CH_3$

bedeuten, wobei der Anteil an Imidylgruppen der Formel I mindestens 5 Prozent, bezogen auf die Anzahl der wiederkehrenden Strukturelemente des Polymeren, beträgt.

2. Ein Polymeres nach Anspruch 1, das Imidylgruppen der Formel I aufweist, worin R und $R_1$ je Wasserstoff, A —$CH_2$—, —$CH_2CH_2$— oder —$OCH_2$— mit an den aromatischen Ring gebundenem Sauerstoffatom und E Wasserstoff bedeuten.

3. Ein Polymeres nach Anspruch 1, worin der Anteil an Imidylgruppen der Formel I 5—100 und bevorzugt 20—100 Prozent, bezogen auf die Anzahl der wiederkehrenden Strukturelemente des Polymeren, beträgt.

4. Ein Polymeres nach Anspruch 1, dadurch gekennzeichnet, dass es sich um ein Polymeres aus der Gruppe der Polyester, Polyesteramide, Polyamide, Polyimide, Polyamid-imide, Polyester-amid-imide, Polyäther, Polyamine, Polyimine, Polyurethane, Polykondensate auf der Basis von Phenol-Formaldehyd, Polysaccharide, Gelatine, Organosiloxane und der Polymeren handelt, die durch Homo- oder Copolymerisation von C=C-Doppelbindungen enthaltenden Monomeren entstehen, handelt.

5. Ein Polymeres nach Anspruch 4, dadurch gekennzeichnet, dass es sich um ein Homo- oder Copolymerisat von reaktive C=C-Doppelbindung enthaltenden Monomeren mit Durchschnittsmolekulargewichten zwischen 1000 und 1 000 000 handelt, und dass dasselbe die Maleinimidgruppen der Formel I in Molekülkettengliedern der Formeln IV bis VII und X bis XIV

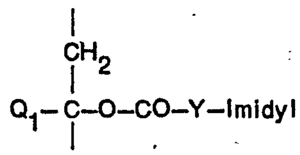

(IV),

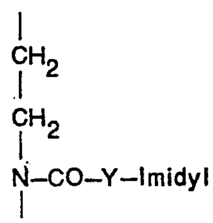

(V),

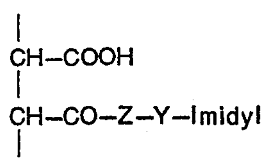

(VI),

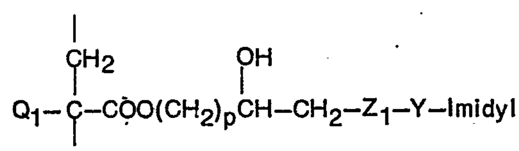

(VII),

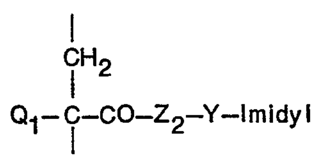

(X),

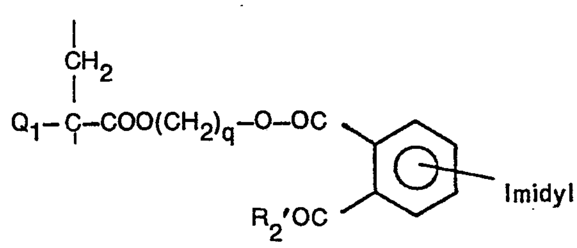

(XI),

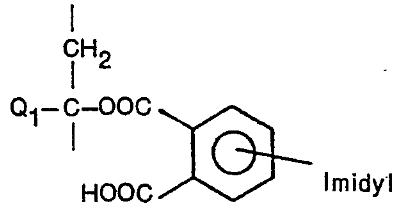

(XII),

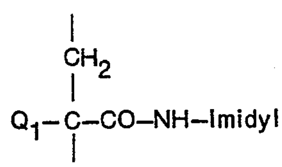

(XIII),

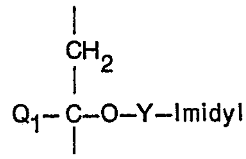

(XIV),

enthält, in denen
"Imidyl"einen Rest der Formel I darstellt,
Y gegebenenfalls durch Heteroatome unterbrochenes Alkylen mit 1—30 C—Atomen, Cycloalkylen mit 5 oder 6 C-Atomen, einen Dicyclohexylmethanrest, Arylen mit 6—10 C-Atomen, Aralkylen oder Alkylarylen mit 7 oder 8 C-Atomen bedeutet, wobei die gennanten Reste Y auch substituiert sein können.
$Q_1$ Wasserstoff oder Methyl,
$R_2'$ —OH oder $—O^-M^+$.
$M^+$ ein Alkalimetall-, Pyridinium- oder Trialkylammoniumkation mit 3—24 C-Atomen,
p die Zahl 1 oder 2,
q eine ganze Zahl von 2 bis 4,
Z —O—, —NH—,

—N-Alkyl
mit 1—4 C-Atomen oder —S—,
$Z_1$, —OCO—, —NH—, —N-Alkyl mit 1—4 C-Atomen, —O— oder —S—, und
$Z_2$ —O—, —S— oder —NH— bedeuten.

6. Ein Polymeres nach Anspruch 5, dadurch gekennzeichnet, dass es ausser einem oder mehreren der Strukturelemente der Formeln IV bis VII und X bis XIV gleichzeitig Strukturelemente der Formel XVI

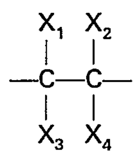

(XVI)

enthalt worin
$X_1$ und $X_3$ je Wasserstoff,
$X_2$ Wasserstoff, Chlor oder Methyl,
$X_4$ Wasserstoff, Methyl, Chlor, —CN, —COOH, $—CONH_2$, Phenyl, Methylphenyl, Methoxyphenyl, Cyclohexyl, Pyridyl, Imidazolyl, Pyrrolidyl, —COO-Alkyl mit 1—12 C-Atomen im Alkylteil, —COO-Phenyl,

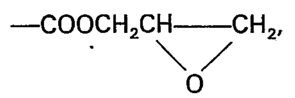

—COO-Alkyl —OH mit 1—3 C-Atomen im Alkylteil, —OCO-Alkyl mit 1—4 C-Atomen im Alkyl, —OCO-Phenyl, —CO-Alkyl mit 1—3 C-Atomen im Alkyl, Alkoxy mit 1—6 C-Atomen oder Phenoxy oder $X_1$ und $X_2$ je Wasserstoff und $X_3$ und $X_4$ zusammen die Gruppierung

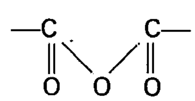

oder je —COOH oder —COOAlkyl mit 1—6 C-Atomen im Alkyl bedeuten.

7. Ein Polymeres nach Anspruch 6, das Strukturelemente der Formel XVI enthält, worin $X_1$ und $X_3$ je Wasserstoff, $X_2$ Wasserstoff oder Methyl und $X_4$ $—OCOCH_3$, —COOH oder —COOAlkyl mit 1—8 C-Atomen im Alkyl bedeuten oder worin $X_1$, $X_2$ und $X_3$ je Wasserstoff und $X_4$ —CN, Chlor oder Phenyl bedeuten.

8. Polymeres nach Anspruch 4, dadurch gekennzeichnet, dass es sich um ein Homo- oder Copolykondensat mit Durchschnittsmolekulargewichten zwischen 1 000 und 50 000 handelt, und dass dasselbe die Maleinimidgruppen der Formel I in Molekülkettengliedern der Formel XV

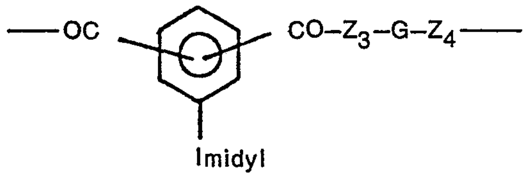

(XV)

enthält, in der "Imidyl" einen Rest der Formel I darstellt,
$Z_3$ und $Z_4$ unabhängig voneinander —O—, —NH— oder —S— und
G einen aliphatischen Rest mit mindestens 2 C-Atomen, einen cycloaliphatischen, araliphatischen, carbocyclisch-aromatischen oder heterocyclisch-aromatischen Rest bedeuten
oder —$Z_3$—G—$Z_4$— eine Gruppierung der Formeln

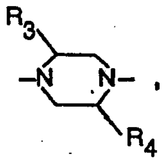 , 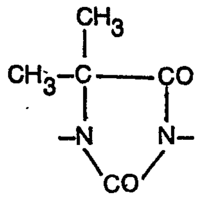 , 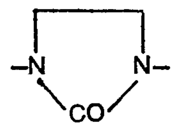 oder

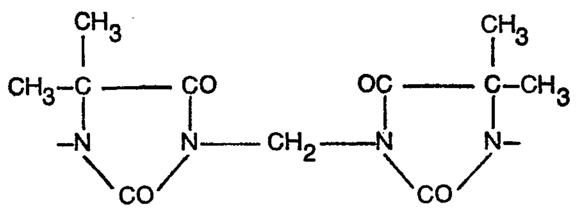 darstellt und

$R_3$ und $R_4$ unabhängig voneinander Wasserstoff, Methyl oder Phenyl bedeuten, wobei in Formel XV die beiden Carbonylgruppen in meta- oder para-Stellung zueinander an den Benzolring gebunden sind.

9. Ein Polymeres nach Anspruch 8, dadurch gekennzeichnet, dass es ausser einem oder mehreren Strukturelementen der Formel XV gleichzeitig Strukturelemente der Formel XVII

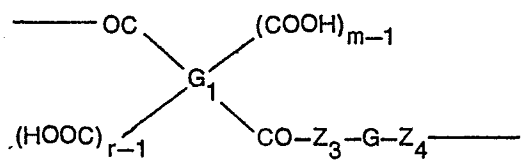

(XVII)

enthält, worin
für $Z_3$, $Z_4$ und G das unter Formel XV Angegebene gilt, m und r unabhängig voneinander die Zahl 1 oder 2,
$G_1$ einen aliphatischen Rest mit mindestens 2 C-Atomen, einen cycloaliphatischen, araliphatischen, carbocyclisch-aromatischen oder heterocyclisch-aromatischen Rest, in dem die Carbonyl- und Carboxylgruppen an verschiedene und bei cyclischen Resten $G_1$ paarweise an benachbarte C-Atome gebunden sind, bedeuten.

10. Ein Polymeres nach Anspruch 8, das wiederkehrende Strukturelemente der Formel XVa

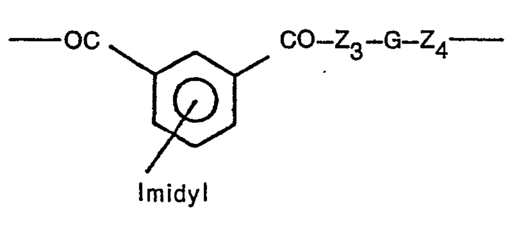

(XVa)

und gegebenenfalls wiederkehrende Strukturelemente der Formel XVIIa

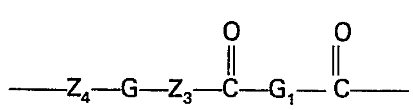

(XVIIa)

aufweist, worin

"Imidyl" einen Rest der Formel I darstellt, in dem R und $R_1$ je Wasserstoff,
A $—CH_2—$, $—CH_2CH_2—$ oder $—OCH_2—$ mit an den aromatischen Ring gebundenem Sauerstoffatom und
E Wasserstoff bedeuten,
$Z_3$ und $Z_4$ je —NH— oder —O—
G Alkylen mit 2—12 C-Atomen oder Arylen mit 6—10 C-Atomen, das durch Halogenatome oder Alkylgruppen mit 1—4 C-Atomen substituiert sein kann und
$G_1$ Alkylen mit 2—10 C-Atomen, 1,3- oder 1,4-Phenylen bedeuten
oder $—Z_4—G—Z_3—$ die Gruppierung

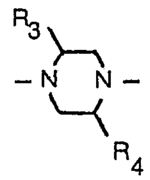

darstellt, worin $R_3$ und $R_4$ je Wasserstoff oder Methyl bedeuten.

11. Ein Polymeres nach Anspruch 4, dadurch gekennzeichnet, dass es sich um ein Produkt mit der Ausgangsbasis Novolak handelt und dass es wiederkehrende Strukturelemente der Formel VIII

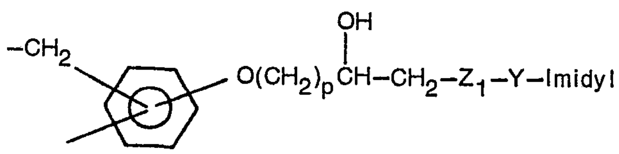

(VIII),

in der p, $Z_1$, Y und Imidyl die gleiche Definition wie in Anspruch 5 haben, aufweist.

12. Ein Polymeres nach Ansprüchen 5 bis 11, dad wiederkehrende Strukturelemente der Formeln IV, V, VI, VII, VIII, X, XII oder XIV und gegebenenfalls wiederkehrende Strukturelemente der Formel XVI aufweist, worin im Imidylrest der Formel I R und $R_1$ je Wasserstoff, A $—CH_2—$, $—CH_2CH_2—$ oder $—OCH_2—$ mit an den aromatischen Ring gebundenem Sauerstoffatom und E Wasserstoff bedeuten, Y geradkettiges oder verzweigtes Alkylen mit 2—11 C-Atomen, 1,3- oder 1,4-Phenylen oder 1,4-Cyclohexylen, Z —O— oder —NH—, $Z_1$ —OCO— oder —NH—, p die Zahl 1, $Q_1$ Methyl oder insbesondere Wasserstoff, $X_1$ und $X_3$ je Wasserstoff, $X_2$ Wasserstoff oder Methyl und $X_4$ $—OCOCH_3$, —COOH oder —COOAlkyl mit 1—8 C-Atomen im Alkyl oder $X_1$, $X_2$ und $X_3$ je Wasserstoff und $X_4$ —CN, Chlor und Phenyl bedeuten.

13. Verwendung eines Polymeren nach Anspruch 1 zur Vernetzung unter der Einwirkung von Licht, besonders zum Erzeugen von Abbildungen.

14. Ein Verfahren zur Herstellung eines Polymeren nach Anspruch 1, dadurch gekennzeichnet, dass man entweder
(a) eine Verbindung der Formel II

$$\text{Imidyl}-\!\left(-Y-\right)_{n-1}\!-X \qquad \text{(II)},$$

worin
"Imidyl" einen Rest der Formel I darstellt,
n die Zahl 1 oder 2 und
Y gegebenenfalls durch Heteroatome unterbrochenes Alkylen mit 1—30 C—Atomen, Cycloalkylen mit 5 oder 6 C-Atomen, einen Dicyclohexylmethanrest, Arylen mit 6—10 C-Atomen, Aralkylen oder Alkylarylen mit 7 oder 8 C-Atomen bedeuten, wobei die genannten Reste Y auch substituiert sein können,
X, bei n = 1, eine Gruppe der Formeln

—NH—CO-alkenyl oder 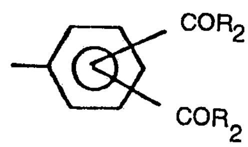

und, bei n = 2, —CO—O-Alkenyl, —O-Alkenyl, —O—CO-Alkenyl, —NH—CO-Alkenyl oder —S—CO-Alkenyl bedeutet, die $—COR_2$ in meta- oder para-Stellung zueinander an den Benzolring gebunden sind und die $R_2$ je —OH, —Cl, Alkoxy mit 1—4 C-Atomen oder Phenoxy bedeuten oder die —$COR_2$ in ortho-Stellung zueinander an den Benzolring gebunden sind und eines von $R_2$ —OH oder —$O^-M^+$ und das andere

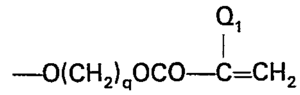

bedeutet oder beide $R_2$ zusammen —O— bilden,
$M^+$ ein Alkalimetall-, Pyridinium- oder Trialkylammoniumkation mit 3—24 C-Atomen,
$Q_1$ Wasserstoff oder Methyl und
q eine ganze Zahl von 2—4 bedeuten, wobei in den obigen Gruppen Alkenylteile 2—4 C-Atome aufweisen, gegebenenfalls in Gegenwart von Comonomeren zur Reaktion bringt, wobei das Mol-Verhältnis von Verbindung der Formel II zu Comonomerem 1:20 bis 1:0 beträgt.
oder
(b) eine Verbindung der Formel III

$$\text{Imidyl}-(-Y-)_{n-1}-X' \qquad \text{(III)},$$

worin
"Imidyl" einen Rest der Formel I darstellt, n die Zahl 1 oder 2 und Y gegebenenfalls durch Heteratome unterbrochenes Alkylen mit 1—30 C-Atomen, Cycloalkylen mit 5 oder 6 C-Atomen, einen Dicyclohexylmethanrest, Arylen mit 6—10 C-Atomen, Aralkylen oder Alkylarylen mit 7 oder 8 C-Atomen bedeuten, wobei die genannten Rest Y auch substituiert sein können,
X', bei n = 1, eine Gruppe der Formel

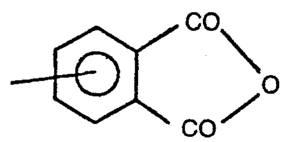

und, bei n = 2, —OH, —$NH_2$, —NH-Alkyl mit 1—4 C-Atomen, —SH, —COOH oder —COCl bedeutet, mit einem Polymeren mit entsprechenden funktionellen Gruppen in einem Verhältnis von 1:20 bis 1:1, bezogen auf die Anzahl der wiederkehrenden Strukturelemente des Polymeren, zur Reaktion bringt.

15. Ein Verfahren nach Anspruch 14, dadurch gekennzeichnet, dass man eine Verbindung der in einem der Ansprüche 1—12 genannten Art herstellt.

**Claims**

1. A novel photo-crosslinkable polymer which has an average molecular weight of at least 1,000 and has side imidyl groups of the formula I

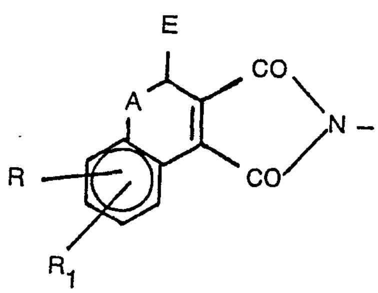

(I)

in which R and $R_1$ independently of one another are hydrogen, halogen, alkyl having 1—4 C atoms or methoxy, A is —$CH_2$—, —$CH_2CH_2$— or —$OCH_2$— with the oxygen atom bonded to the aromatic ring and E is hydrogen, or A is —O— and E is —$CH_3$, the proportion of imidyl groups of the formula I being at least 5 per cent, based on the number of recurring structural elements in the polymer.

2. A polymer according to claim 1, which contains imidyl groups of the formula I in which R and $R_1$ are each hydrogen, A is —$CH_2$—, —$CH_2CH_2$— or —$OCH_2$— with the oxygen atom bonded to the aromatic ring and E is hydrogen.

3. A polymer according to claim 1, in which the proportion of imidyl groups of the formula I is

5—100 and preferably 20—100 per cent, based on the number of recurring structural elements in the polymer.

4. A polymer according to claim 1, which is a polymer from the group comprising the polyesters, polyester-amides, polyamides, polyimides, polyamide-imides, polyester-amide-imides, polyethers, polyamines, polyimines, polyurethanes, polycondensation products based on phenol-formaldehyde, polysaccharides, gelatin, organosiloxanes and the polymers which are obtained by homopolymerisation or copolymerisation of monomers containing C=C double bonds.

5. A polymer according to claim 4, which is a homopolymer or copolymer of monomers containing reactive C=C double bonds, which has an average molecular weight of between 1,000 and 1,000,000, wherein the said polymer contains maleimide groups of the formula I in molecule chain members of the formulae IV to VII and X to XIV

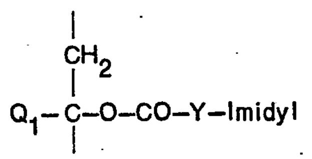

(IV),

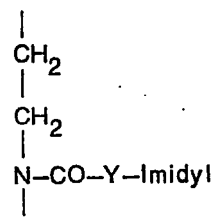

(V),

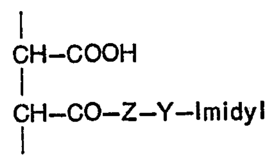

(VI),

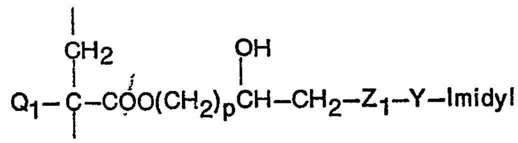

(VII),

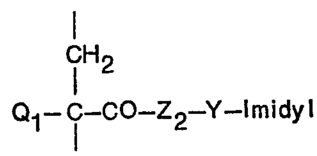

(X),

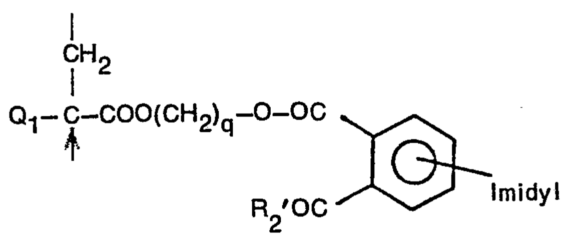

(XI),

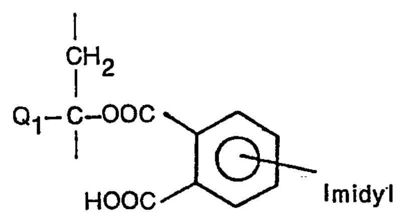

(XII),

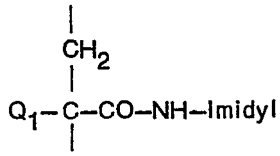

(XIII) and

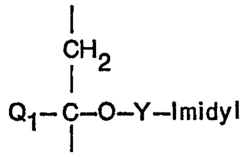

(XIV),

in which "imidyl" is a radical of the formula I, Y is alkylene having 1—30 C atoms, which can be interrupted by hetero-atoms, or is cycloalkylene having 5 or 6 C atoms, a dicyclohexylmethane radical, arylene having 6—10 C atoms, or aralkylene or alkylarylene having 7 or 8 C atoms, it being possible for the said radicals Y also to be substituted, and $Q_1$ is hydrogen or methyl, $R_2'$ is —OH or $—O^-M^+$, $M^+$ is an alkali metal cation, a pyridinium cation or a trialkylammonium cation having 3—24 C atoms, p is the number 1 or 2, q is an integer from 2 to 4, Z is —O—, —NH—,

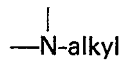

having 1—4 C atoms, —O— and $Z_2$ is —O—, —S— or —NH—.

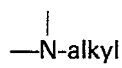

having 1—4 C atoms, —O— and $Z_2$ is —O—, —S— or —NH—.

6. A polymer according to claim 5, which, in addition to one or more of the structural elements of the formulae IV to VII and X to XIV, at the same time contains structural elements of the formula XVI

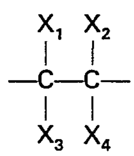

(XVI)

in which $X_1$ and $X_3$ are each hydrogen, $X_2$ is hydrogen, chlorine or methyl and $X_4$ is hydrogen, methyl, chlorine, —CN, —COOH, $—CONH_2$, phenyl, methylphenyl, methoxyphenyl, cyclohexyl, pyridyl, imidazolyl, pyrrolidyl, —COO-alkyl having 1—12 C atoms in the alkyl moiety, —COO-phenyl,

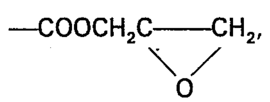

—COO-alkyl-OH having 1—3 C atoms in the alkyl moiety, —OCO-alkyl having 1—4 C atoms in the alkyl, —OCO-phenyl, —CO-alkyl having 1—3 C atoms in the alkyl, alkoxy having 1—6 C atoms or phenoxy, or $X_1$ and $X_2$ are each hydrogen and $X_3$ and $X_4$ together are the grouping

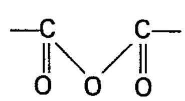

or each are —COOH or —COO-alkyl having 1—6 C atoms in the alkyl.

7. A polymer according to claim 6, which contains structural elements of the formula XVI, in which $X_1$ and $X_3$ are each hydrogen, $X_2$ is hydrogen or methyl and $X_4$ is $—OCOCH_3$, —COOH or —COO-alkyl having 1—8 C atoms in the alkyl, or in which $X_1$, $X_2$ and $X_3$ are each hydrogen and $X_4$ is —CN, chlorine or phenyl.

8. A polymer according to claim 4, which is a homopolycondensation product or copolycondensation product with an average molecular weight of between 1,000 and 50,000, wherein the said polycondensation product contains maleimide groups of the formula I in molecule chain members of the formula XV

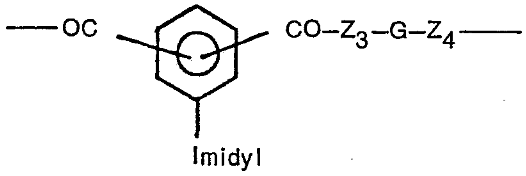

(XV)

in which "imidyl" is a radical of the formula I, $Z_3$ and $Z_4$ independently of one another are —O—, —NH— or —S— and G is an aliphatic radical having at least 2 C atoms or a cycloaliphatic, araliphatic, carbocyclic-aromatic or heterocyclic-aromatic radical, or $Z_3$—G—$Z_4$— is a grouping of the formulae

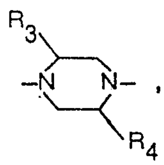 , 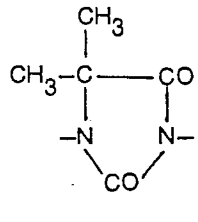 , 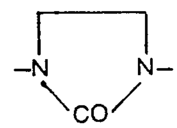 or

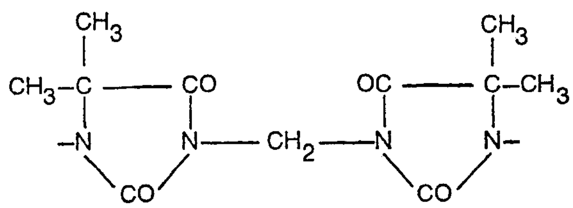

and $R_3$ and $R_4$ independently of one another are hydrogen, methyl or phenyl, the two carbonyl groups in the formula XV being bonded to the benzene ring in the meta- or para-position relative to one another.

9. A polymer according to claim 8, which, in addition to one or more structural elements of the formula XV, at the same time contains structural elements of the formula XVII

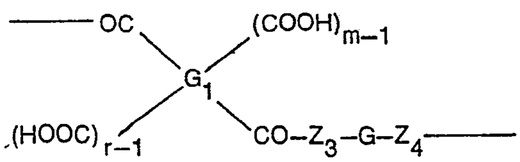

(XVII)

in which $Z_3$, $Z_4$ and G are as defined under formula XV, m and r independently of one another are the number 1 or 2 and $G_1$ is an aliphatic radical having at least 2 C atoms or a cycloaliphatic, araliphatic, carbocyclic-aromatic or heterocyclic-aromatic radical and in which the carbonyl and carboxyl groups are bonded to different C atoms and, in the case of cyclic radicals $G_1$, are bonded in pairs to adjacent C atoms.

10. A polymer according to claim 8, which contains recurring structural elements of the formula XVa

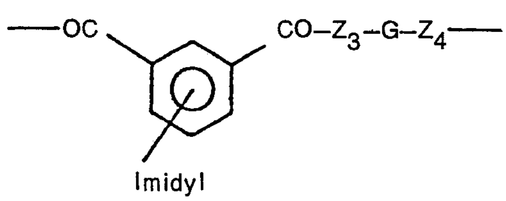

(XVa)

and can contain recurring structural elements of the formula XVIIa

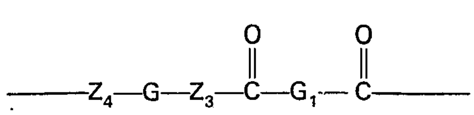

(XVIIa)

in which formulae "imidyl" is a radical of the formula I in which R and $R_1$ are each hydrogen, A is $—CH_2—$, $—CH_2CH_2—$ or $—OCH_2—$ with the oxygen atom bonded to the aromatic ring and E is hydrogen, and $Z_3$ and $Z_4$ are each —NH— or —O—, G is alkylene having 2—12 C atoms or arylene having 6—10 C atoms, which can be substituted by halogen atoms or alkyl groups having 1—4 C atoms, and $G_1$ is alkylene having 2—10 C atoms or 1,3- or 1,4-phenylene, or $—Z_4—G—Z_3—$ is the grouping

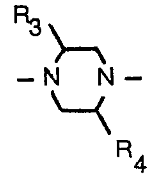

in which $R_3$ and $R_4$ are each hydrogen or methyl.

11. A polymer according to claim 4, which is a product which is based on novolac as the starting material and which contains recurring structural elements of the formula VIII

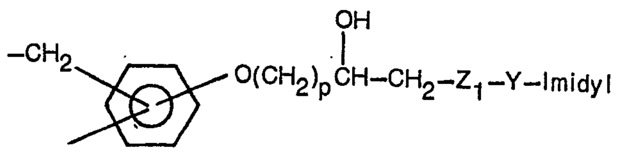
(VIII)

in which p, $Z_1$, Y and imidyl are as defined in claim 5.

12. A polymer according to claims 5 to 11, which contains recurring structural elements of the formulae IV, V, VI, VII, VIII, X, XII or XIV and can contain recurring structural elements of the formula XVI and in which, in the imidyl radical of the formula I, R and $R_1$ are each hydrogen, A is $—CH_2—$, $—CH_2CH_2—$ or $—OCH_2—$ with the oxygen atom bonded to the aromatic ring and E is hydrogen, Y is a straight-chain or branched alkylene having 2—11 C atoms, 1,3- or 1,4-phenylene or 1,4-cyclohexylene, Z is —O— or —NH—, $Z_1$ is —OCO— or —NH—, p is the number 1, $Q_1$ is methyl or in particular hydrogen and $X_1$ and $X_3$ are each hydrogen, $X_2$ is hydrogen or methyl and $X_4$ is $—OCOCH_3$, —COOH or —COO-alkyl having 1—8 C atoms in the alkyl, or $X_1$, $X_2$ and $X_3$ are each hydrogen and $X_4$ is —CN, chlorine or phenyl.

13. The use of a polymer according to claim 1 for photo-crosslinking, especially for the production of images.

14. A process for the preparation of a polymer according to claim 1, which comprises either

(a) reacting a compound of the formula II

$$\text{imidyl}-(Y)_{n-1}-X \qquad \text{(II)}$$

in which "imidyl" is a radical of the formula I, n is the number 1 or 2 and Y is alkylene having 1—30 C atoms, which can be interrupted by hetero-atoms, or is cycloalkylene having 5 or 6 C atoms, a dicyclohexylmethane radical, arylene having 6—10 C atoms, or aralkylene or alkylarylene having 7 or 8 C atoms, it being possible for the said radicals Y also to be substituted, and X, when n=1, is a group of the formulae —NH—CO-alkenyl or

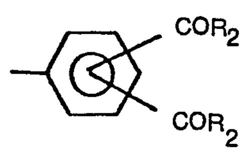

and, when n=2, is —CO—O-alkenyl, —O-alkenyl, —O—CO-alkenyl, —NH—CO-alkenyl or —S—CO-alkenyl, the $—COR_2$s are bonded to the benzene ring in the meta- or para-position relative to one another and the $R_2$s are each —OH, —Cl, alkoxy having 1—4 C atoms or phenoxy, or the $—COR_2$s are bonded to the benzene ring in the ortho-position relative to one another and one of the $R_2$s is —OH or $—O^-M^+$ and the other is

$$—O(CH_2)_qOCO—\overset{\displaystyle Q_1}{\overset{|}{C}}=CH_2,$$

or the two $R_2$s together are —O—, and $M^+$ is an alkali metal cation, the pyridinium cation or a

trialkylammonium cation having 3—24 C atoms, $Q_1$ is hydrogen or methyl and q is an integer from 2 to 4, and, in the above groups, alkenyl moieties have 2—4 C atoms, if desired in the presence of comonomers, the molar ratio of the compound of the formula II to the comonomer being 1:20 to 1:0, or

(b) reacting a compound of the formula III

$$\text{imidyl}-(Y)_{n-1}-X' \quad \text{(III)}$$

in which "imidyl" is a radical of the formula I, n is the number 1 or 2 and Y is alkylene having 1—30 C atoms, which can be interrupted by hetero-atoms, or is cycloalkylene having 5 or 6 C atoms, a dicyclohexylmethane radical, arylene having 6—10 C atoms, or aralkylene or alkylarylene having 7 or 8 C atoms, it being possible for the said radicals Y also to be substituted, and X', when n=1, is a group of the formula

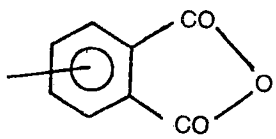

and, when n=2, is —OH, —$NH_2$, —NH-alkyl having 1—4 C atoms, —SH, —COOH or —COCl, with a polymer containing corresponding functional groups in a ratio of 1:20 to 1:1, based on the number of recurring structural elements in the polymer.

15. A process according to claim 14, wherein a compound of the type named in any one of claims 1 to 12 is prepared.

## Revendications

1. Polymère réticulable sous l'action de la lumière, dont le poids moléculaire moyen est d'au moins 1000 et qui porte des radicaux imidyles latéraux répondant à la formule I

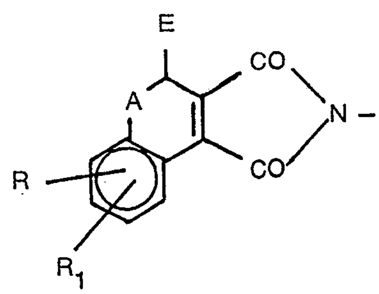

(I)

dans laquelle

R et $R_1$ représentent chacun, indépendamment l'un de l'autre, l'hydrogène, un halogène, un alkyle en $C_1$—$C_4$ ou un méthoxy,

A représente un radical —$CH_2$— ou —$CH_2CH_2$— ou un radical —$OCH_2$— qui est relié par son atome d'oxygène au noyau aromatique et

E représente l'hydrogène,

ou

A représente —O— et

E représente —$CH_3$,

la proportion des radicaux imydyles de formule I étant d'au moins 5% par rapport au nombre des éléments structuraux répétés (motifs) du polymère.

2. Polymère selon la revendication 1 qui porte des radicaux imidyles de formule I dans lesquels R et $R_1$ représentent chacun l'hydrogène, A représente un radical —$CH_2$— ou —$CH_2CH_2$— ou un radical —$OCH_2$— relié par son atome d'oxygène au noyau aromatique, et E représente l'hydrogène.

3. Polymère selon la revendication 1 dans lequel la proportion des radicaux imidyles de formule I est de 5 à 100%, de préférence de 20 à 100%, par rapport au nombre des motifs du polymère.

4. Polymère selon la revendication 1, caractérisé en ce qu'il appartient à l'ensemble constitué par les polyesters, les polyester-amides, les polyamides, les polyimides, les polyamide-imides, les polyester-amide-imides, les polyéthers, les polyamines, les polyimines, les polyuréthannes, les produits de condensation phénol-phormaldéhyde, les poly-saccharides, la gélatine, les organo-siloxanes et les polymères formés par homopolymérisation ou copolymérisation de monomères contenant des doubles liaisons C=C.

5. Polymère selon la revendication 4, caractérisé en ce qu'il est un homopolymère ou un copolymère de monomères à doubles liaisons C=C réactives qui a un poids moléculaire moyen compris

entre 1000 et 1 000 000 et en ce qu'il contient des radicaux maléimidyles de formule I dans des maillons de chaînes moléculaires de formules IV à VII et X à XIV:

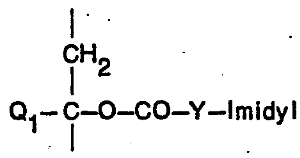

(IV),

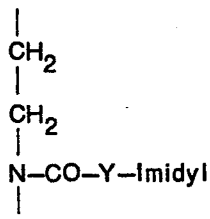

(V),

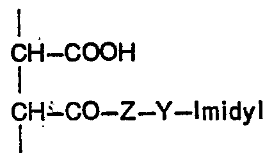

(VI),

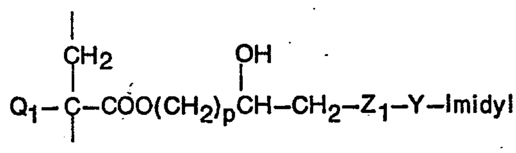

(VII),

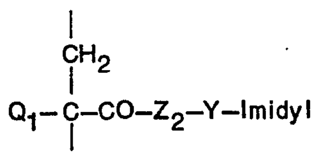

(X),

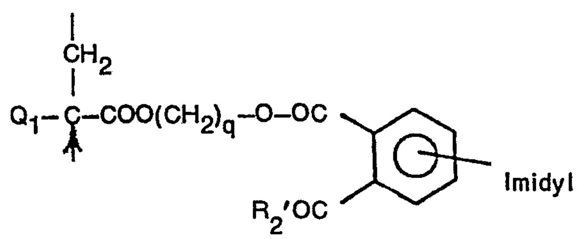

(XI),

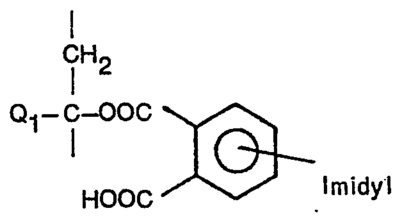

(XII),

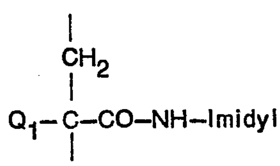

(XIII),

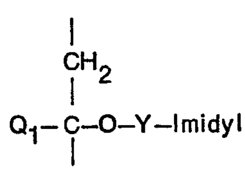

(XIV),

formules dans lesquelles:
"Imidyl" représente un radical de formule I,

Y représente un radical alkylène en $C_1$—$C_{30}$ "éventuellement interrompu par des hétéro-atomes, un cycloalkylène à 5 ou 6 atomes de carbone, un radical de dicyclo-hexyl-méthane, un arylène en $C_6$—$C_{10}$, ou un radical aralkylène ou alkylarylène à 7 ou 8 atomes de carbone, les radicaux Y mentionnés pouvant également porter des substituants,

$Q_1$ représente l'hydrogène ou un méthyle,

$R_2'$ représente un groupe —OH ou —$O^-M^+$,

$M^+$ représente un cation de métal alcalin, un cation de pyridinium ou un cation de trialkylammonium contenant de 3 à 24 atomes de carbone,

p désigne le nombre 1 ou 2,

q représente un nombre entier de 2 à 4,

Z représente —O—, —NH—, un radical

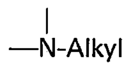

contenant de 1 à 4 atomes de carbone ou —S—,

$Z_1$ représente —OCO—, —NH—, un radical

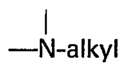

en $C_1$—$C_4$, —O— ou —S—, et

$Z_2$ représente —O—, —S— ou —NH—.

6. Polymère selon la revendication 5 caractérisé en ce qu'en plus d'un ou plusieurs des motifs de formules IV à VII et X à XIV il contient des motifs répondant à la formule XVI

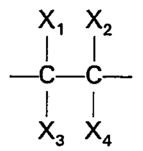

(XVI)

dans laquelle

$X_1$ et $X_3$ représentent chacun l'hydrogène,

$X_2$ représente l'hydrogène, le chlore ou un méthyle,

$X_4$ représente l'hydrogène, un méthyle, le chlore, —CN—, —COOH, —$CONH_2$, un phényle, un méthylphényle, un méthoxyphényle, un cyclohexyle, un pyridyle, un imidazolyle, un pyrrolidyle, un radical —COO-Alkyl contenant de 1 à 12 atomes de carbone dans la partie alkyle, —COO-Phényle,

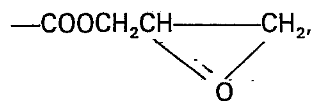

un radical —COO-Alkyl-OH contenant de 1 à 3 atomes de carbone dans la partie alkyle, un radical —OCO-Alkyl contenant de 1 à 4 atomes de carbone dans la partie alkyle, —OCO-Phényl, un radical —CO-Alkyl contenant de 1 à 3 atomes de carbone dans la partie alkyle, un alcoxy en $C_1$—$C_6$ ou un phénoxy, ou

$X_1$ et $X_2$ représentent chacun l'hydrogène et

$X_3$ et $X_4$ forment ensemble un groupement

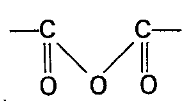

ou représentent chacun un groupe —COOH ou un groupe —COOAlkyl contenant de q à 6 atomes de carbone dans la partie alkyle.

7. Polymère selon la revendication 6 qui contient des motifs de formule XVI dans lesquels $X_1$ et $X_3$ représentent chacun l'hydrogène, $X_2$ représente l'hydrogène ou un méthyle et $X_4$ représente —$OCOCH_3$, —COOH ou un radical —COOAlkyl contenant de 1 à 8 atomes de carbone dans la partie alkyle, ou dans lesquels $X_1$, $X_2$ et $X_3$ représentent chacun l'hydrogène et $X_4$ représente —CN, le chlore ou un phényle.

8. Polymère selon la revendication 4 caractérisé en ce qu'il est un homopolycondensat ou un copolycondensat de poids moléculaire moyen compris entre 1000 et 50 000 et en ce qu'il contient des radicaux maléimidyles de formule I dans des maillons de chaînes moléculaires répondant à la formule XV

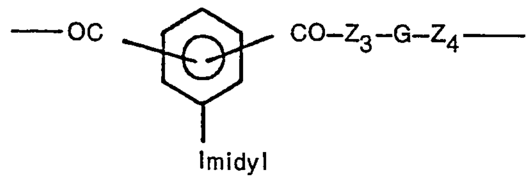

(XV)

dans laquelle

"Imidyl" représente un radical de formule I,

$Z_3$ et $Z_4$ représentent chacun, indépendamment l'un de l'autre, —O—, —NH— ou —S— et

G représente un radical aliphatique contenant au moins deux atomes de carbone, ou un radical cycloaliphatique, araliphatique, carbocyclique-aromatique ou hétérocyclique-aromatique, ou

$Z_3$—G—$Z_4$ représente un groupement répondant à l'une des formules suivantes:

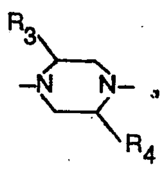 , 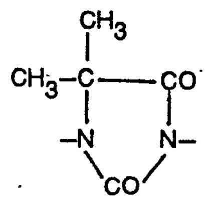 , 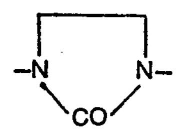 et

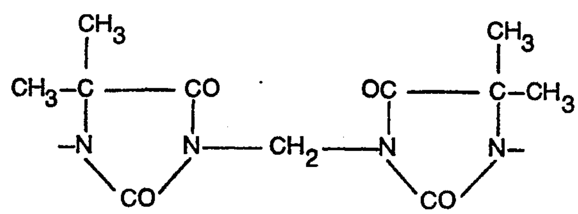 et

$R_3$ et $R_4$ représentent chacun, indépendamment l'un de l'autre, l'hydrogène, un méthyle ou un phényle, les deux groupes carbonyles présents dans la formule XV étant en position méta ou para l'un par rapport à l'autre sur le noyau benzénique.

9. Polymère selon la revendication 8 caractérisé en ce qu'en plus d'un ou plusieurs motifs de formule XV il contient des motifs répondant à la formule XVII

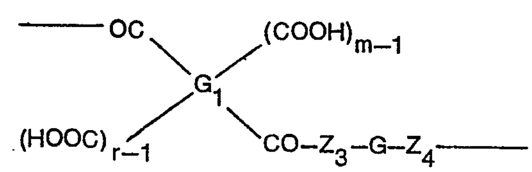

(XVII)

dans laquelle

$Z_3$, $Z_4$ et G ont les significations données à propos de la formule XV,

m et r représentent chacun, indépendamment l'un de l'autre, le nombre 1 ou le nombre 2, et

$G_1$ représente un radical aliphatique contenant au moins deux atomes de carbone ou un radical cycloaliphatique, araliphatique, carbocyclique-aromatique ou hétérocyclique-aromatique, dans lequel les groupes carbonyles et carboxy se trouvent sur des atomes de carbone différents et, dans le cas de radicaux cycliques, $G_1$, deux par deux sur des atomes de carbone voisins.

10. Polymère selon la revendication 8 contenant des motifs de formule XVa

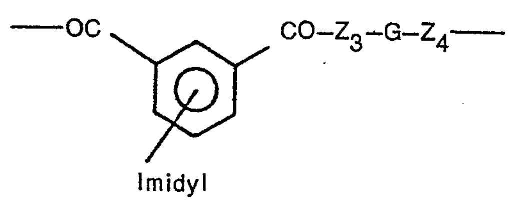

(XVa)

et éventuellement des motifs de formule XVIIa

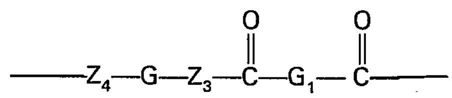

(XVIIa)

formules dans lesquelles:

"Imidyl" représente un radical de formule I dans lequel R et $R_1$ représentent chacun cl'hydrogène, A représente un radical $-CH_2-$, $-CH_2CH_2-$ ou un radical $-OCH_2-$ relié par son atome d'oxygène au noyau aromatique et E représente l'hydrogène,

$Z_3$ et $Z_4$ représentent chacun —NH— ou —O—,

G représente un alkylène en $C_2$—$C_{12}$ ou un arylène en $C_6$—$C_{10}$ qui peut porter des atomes d'halogènes ou des radicaux alkyles en $C_1$—$C_4$, et

$G_1$ représente un alkylène en $C_2$—$C_{10}$ ou un phènylène -1,3 ou -1,4

ou

$-Z_4-G-Z_3-$ représentent un groupement

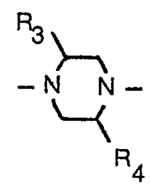

dans lequel $R_3$ et $R_4$ représentent chacun l'hydrogène ou un méthyle.

11. Polymère selon la revendication 4 caractérisé en ce qu'il est un produit dérivant d'une novolaque et en ce qu'il contient des motifs répondant à la formule VIII

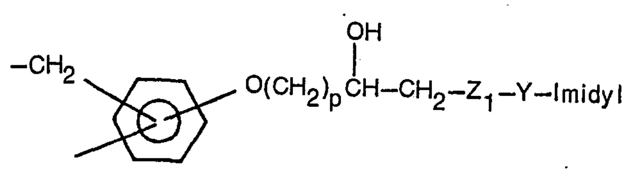

(VIII).

dans laquelle p, $Z_1$, Y et Imidyl ont les significations données à la revendication 5.

12. Polymère selon l'une quelconque des revendications 5 à 11, qui contient des motifs de formules IV, V, VI, VII, VIII, X, XII ou XIV et éventuellement des motifs de formule XVI, dans lesquels, sur le radical imidyle de formule I, R et $R_1$ représentent chacun l'hydrogène, A représente un radical $-CH_2-$ ou $-CH_2CH_2-$ ou un radical $-OCH_2-$ relié par son atome d'oxygène au noyau aromatique et E représente l'hydrogène, Y représente un alkylène en $C_2$—$C_{11}$ linéaire ou ramifié, un phénylène-1,3 ou -1,4 ou un cyclohexylène-1,4, Z représente —O— ou —NH—, $Z_1$ représente —OCO— ou —NH—, p désigne le nombre 1, $Q_1$ représente un méthyle ou, plus particulièrement, l'hydrogène, $X_1$ et $X_3$ représentent chacun l'hydrogène, $X_2$ représente l'hydrogène ou un méthyle et $X_4$ représente $-OCOCH_3$, —COOH ou un radical —COOAlkyl contenant de 1 à 8 atomes de carbone dans sa partie alkyle, ou $X_1$, $X_2$ et $X_3$ représentent chacun l'hydrogène et $X_4$ représente —CN, le chlore ou un phényle.

13. Application d'un polymère selon la revendication 1 à la réticulation sous l'action de la lumière, en particulier pour la production d'images.

14. Procédé de préparation d'un polymère selon la revendication 1, procédé caractérisé en ce que ou bien:

(a) On fait réagir un composé répondant à la formule II

$$\text{Imidyl}-(Y)_{n-1}-X \quad \text{(II)}$$

dans laquelle

"Imidyl" représente un radacal de formule I,

n désigne le nombre 1 ou 2,

Y représente un alkylène en $C_1$—$C_{30}$ éventuellement interrompu par des hétéroatomes, un cycloalkylène en $C_5$ ou $C_6$, un radical de dicyclohexyl-méthane, un arylène en $C_6$—$C_{10}$, ou un radical aralkylène ou alkylarylène à 7 ou 8 atomes de carbone, les radicaux Y mentionnés pouvent également être substitués,

X représente, dans le cas où n est égal à 1, un radical répondant à l'une des formules

—NH—CO-Alcényl et 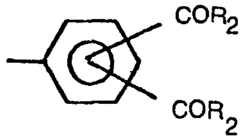

et, lorsque n est égal à 2, un radical —CO—O-Alcényl, —O—Alcényl, —O—CO-Alcényl, —NH—CO-Alcényl ou —S—CO-Alcényl,

les

$—COR_2$ sont en méta ou en para l'un par rapport à l'autre sur le noyau benzénique et les $R_2$ représentent chacun —OH, —Cl, un alcoxy en $C_1$—$C_4$ ou un phénoxy, ou

les

$—COR_2$ sont en ortho l'un par rapport à l'autre sur le noyau benzénique et l'un des $R_2$ représente —OH ou $—O^-M^+$ et l'autre représente un radical

$$—O(CH_2)_qOCO—\overset{\displaystyle Q_1}{\overset{|}{C}}=CH_2$$

ou les deux $R_2$ forment ensemble —O—,

$M^+$ représente un cation de métal alcalin, un cation pyridinium ou un cation trialkylammonium, contenant de 3 à 24 atomes de carbone,

$Q_1$ représente l'hydrogène ou un méthyle et

q représente un nombre entier de 2 à 4,

(les parties alcényles dans ceux des radicaux qui en contiennent renferment de 2 à 4 atomes de carbone), éventuellement en présence de comonomères, le rapport molaire du composé de formule II au comonomère étant compris entre 1:20 et 1:0,

ou

(b) on fait réagir un composé répondant à la formule III

$$\text{Imidyl}-(Y)_{n-1}-X' \qquad \text{(III)}$$

dans laquelle

"Imidyl" représente un radical de formule I,

n désigne le nombre 1 ou 2 et

Y représente un alkylène en $C_1$—$C_{30}$ éventuellement interrompu par des hétéro-atomes, un cycloalkylène en $C_5$ ou $C_6$, un radical de dicyclohexyl-méthane, un arylène en $C_6$—$C_{10}$ ou un radical aralkylène ou alkylarylène à 7 ou 8 atomes de carbone, les radicaux Y mentionnés pouvent également être substitués, et

X' représente, lorsque n est égal à 1, un radical de formule

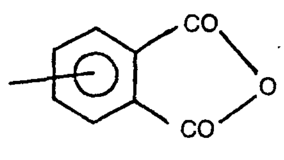

et, lorsque n est égal à 2, un groupe —OH, $—NH_2$, un radical —NH-Alkyl en $C_1$—$C_4$, —SH, —COOH ou COCl,

avec un polymère porteur de groupes fonctionnels correspondants, dans un rapport de 1:20 à 1:1, par rapport au nombre des motifs du polymère.

15. Procédé selon la revendication 14, caractérisé en ce qu'on prépare un composé du type indiqué dans les revendications 1 à 12.